(19) Europäisches Patentamt
European Patent Office
Office européen des brevets

(11) Publication number: **0 005 380**
**B1**

(12) **EUROPEAN PATENT SPECIFICATION**

(45) Date of publication of patent specification: **06.01.82**

(51) Int. Cl.³: **G 03 C 1/68**, G 03 C 1/733, G 03 F 7/02

(21) Application number: **79300796.4**

(22) Date of filing: **09.05.79**

(54) **Phototropic photosensitive compositions containing a fluoran colorformer.**

(30) Priority: **09.05.78 US 904145**

(43) Date of publication of application:
**14.11.79 Bulletin 79/23**

(45) Publication of the grant of the European patent:
**06.01.82 Bulletin 82/1**

(84) Designated Contracting States:
**BE CH DE FR GB NL SE**

(56) References cited:
DE - A - 1 931 482
DE - A - 2 049 503
DE - A - 2 306 353
DE - A - 2 433 252
DE - A - 2 824 928
GB - A - 1 146 497
GB - A - 1 269 601
GB - A - 1 339 316

(73) Proprietor: **Dynachem Corporation**
**2632 Michelle Drive**
**Tustin California 92680 (US)**

(72) Inventor: **Reardon, Edward Joseph, Jr.**
**21795 Meadowview Lane**
**El Toro California 92630 (US)**

(74) Representative: **Hose, Cyril Gustav Bidwell et al,**
**Baron & Warren 18 South End Kensington**
**London W8 5BU (GB)**

(56) References cited:
US - A - 3 501 331
US - A - 3 514 310
US - A - 3 767 408
US - A - 3 769 023
US - A - 3 929 831
US - A - 4 007 195
US - A - 4 065 315

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Phototropic photosensitive compositions containing a fluoran colorformer

This invention relates to phototropic photosensitive compositions containing the free base of a fluoran dyestuff.

Two techniques widely used in the fabrication of printed circuit boards are the additive process and the subtractive process.

In the manufacture of printed circuit boards by the subtractive process, there is adhered to the surface of a copper-clad laminate one surface of a dry, photoresist film; the other surface of the film is adhered to a film support. The photoresist layer is thereafter exposed to light according to a predetermined pattern. The support film is thereafter removed and the copper layer is exposed by washing away the unexposed areas of the photoresist layer. The exposed copper layer is then etched away by chemical milling.

In the additive process, there is adhered to the surface of a substrate (which may or may not be copper-clad) one surface of a dry photoresist film; the other surface is adhered to a film support. The dry photoresist layer is thereafter exposed to a predetermined light pattern and the support film is thereafter removed. The substrate is exposed by washing away the unexposed areas of the photoresist layer. At this point, the substrate is treated with appropriate sensitizers and metalizing solutions, whereby a layer of metal, usually copper, is applied to the substrate.

The dry photoresist films are typically formulated to contrast in color with the substrates with which they are used. Since they generally do not change color, it is extremely difficult to inspect the product after exposure to light and prior to removal of the unexposed areas of the photoresist film to insure that the light mask has been properly placed and to be sure that there are no imperfections or defects in the exposed photopolymerizable layer. It is extremely useful to have a dry photoresist film which visually indicates where the film has been exposed to light so that detection of defects can readily be made prior to developing the film and etching the copper-clad panels or building up a layer of metal on the exposed substrate.

It would also be useful to have a liquid photopolymerisable system that is colorless or lightly colored in the unexposed state and which both crosslinks and becomes intensely colored upon exposure to actinic light.

Prior artisans who have concerned themselves with phototropic photosensitive systems have attempted to use, as colorformers, arylamines, leuco triphenylmethane dyes and the free bases of ketone imine dyes, of aminotriarylmethane dyes, of aminoxanthene dyes, of aminoacridine dyes, of methine and of polymethine dyes. (US—A—4065315).

Fluoran colorformers can be used to formulate stable phototropic photosensitive compositions which comprise

(a) at least one component capable of curing, crosslinking or polymerizing upon suitable initiation,

(b) an initiator for said component that is potentiated by actinic radiation,

(c) a fluoran colorformer capable of becoming more intensely colored upon contact with a color activator, and

(d) a latent activator for the fluoran colorformer that is capable of activating the fluoran colorformer under the influence of actinic light.

The composition may be a dry photoimagable composition, in the form of a thin layer, especially an assembly comprising a support sheet, a layer of said dry phototropic photosensitive composition, one surface of which is adhered to the support sheet, and a transparent sheet adhered to the other surface of said layer of composition.

The composition may be said phototropic photosensitive composition upon a support which may be a conductive metal layer, one surface of which is in contact with a coextensive surface of an insulating layer: alternatively the support may be non-conductive.

The composition may be a solvent-free liquid, actinic radiation curable coating or printing composition comprising the aforesaid ingredients.

These compositions can be applied as decorative or protective coatings to provide highly colored cured products upon exposure to actinic radiation.

The present invention provides a phototropic, photosensitive composition, such as a film, comprising (a) at least one component which is capable of curing, crosslinking or polymerizing upon initiation, such as a compound containing an acrylyl or methacrylyl group, (b) at least one initiator for the component (a) which is potentiated by actinic radiation, (c) the free base of a dyestuff that forms a halide salt which is more intensely coloured than the free base, and (d) a latent activator which releases free halogen radicals when exposed to actinic light and comprises a halogen-containing organic compound, said composition being characterized in that it contains the free base of a fluoran dyestuff that forms a halide salt and has the general formula

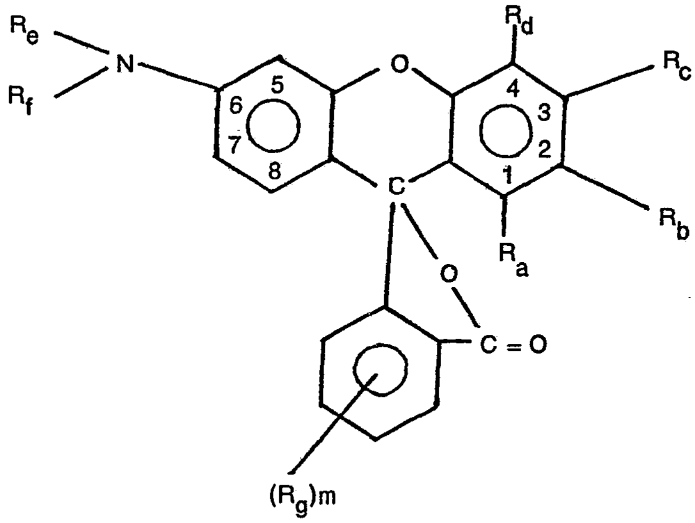

in which $R_a$ is a hydrogen or halogen atom or an aliphatic hydrocarbon or hydrocarbonoxy group having 1 to 12 carbon atoms which may be interrupted by —NH— or —O— and may be substituted: Rb is a primary, secondary or tertiary amino group in which the substituents on the nitrogen atom, when present, are aliphatic, cycloaliphatic, aromatic or araliphatic hydrocarbon groups which may be substituted or Rb is a heterocyclic group having 2 to 12 ring atoms which is linked through a nitrogen atom and may, in addition, have oxygen and/or sulphur as ring atoms; or $R_a$ and $R_b$ may together form a condensed aromatic nucleus, $R_c$ is a hydrogen or halogen atom or an aliphatic hydrocarbon or hydrocarbonoxy group having 1 to 12 carbon atoms which may be interrupted by nitrogen or oxygen, or a primary, secondary or tertiary amino group in which the substituents on the nitrogen atom, when present, are aliphatic, cycloaliphatic, aromatic or araliphatic hydrocarbon groups which may be substituted, or $R_c$ is a heterocyclic group having 3 to 12 ring atoms and may, in addition, have oxygen and/or sulphur as ring atoms, or $R_c$ is an aromatic hydrocarbon group which may be substituted, an araliphatic group or an aromatic ether or an aromatic-aliphatic ether group; $R_d$ is a hydrogen atom, a lower aliphatic hydrocarbon or hydrocarbonoxy group or a primary, secondary or tertiary amino group in which the substituents on the nitrogen atom, when present, are aliphatic, cycloaliphatic, aromatic or araliphatic hydrocarbon groups which may be substituted or Rd is a heterocyclic group having 3 to 12 ring atoms and containing one or more of nitrogen, oxygen and sulphur as ring atoms: each of Re and Rf is a hydrogen atom or an aliphatic hydrocarbon group having 1 to 12 carbon atoms and may be substituted and may be interrupted by oxygen or nitrogen, a cycloaliphatic, aromatic or araliphatic hydrocarbon group or Re and Rf together with the nitrogen atom to which they are attached form a heterocyclic ring having 3 to 12 ring atoms and may, in addition, have oxygen and/or sulphur as ring atoms: each (Rg) is a hydrogen or halogen atom, a lower aliphatic hydrocarbon or hydrocarbonoxy group, or an acetamido or primary, secondary or tertiary amino group; m is an integer from 1 to 3 and at least one of Rb, Rc and Rd is an amino group.

As used herein, the term "phototropic" is intended to identify the capability of a system, such as the composition described above, to darken in response to actinic light; the term is derived from "photo" — indicating light or radiant energy and "tropic" — changing or tending to change in a specified manner in response to a specified stimulus.

Particularly useful are the 2-amino fluoran free bases having the general formula

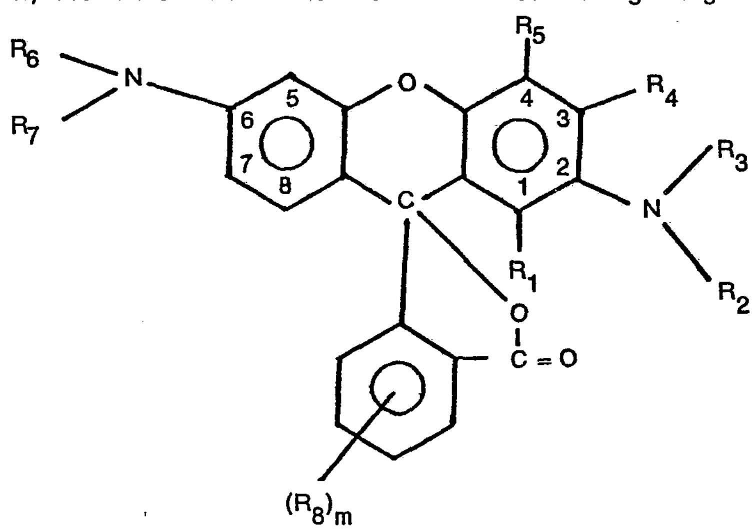

where

$R_1$ is hydrogen, halogen, alkyl of one to 12 carbon atoms, alkoxy of one to 12 carbon atoms

$R_2$ and $R_3$ each independently is hydrogen, alkyl of one to 12 carbon atoms, alkenyl or 2 to 12 carbon atoms alkoxyalkyl of 2 to 8 carbon atoms, alkoxycarbonylalkyl of 3 to 9 carbon atoms, cycloalkyl of 5 or 6 carbon atoms, acyl of one to 12 carbon atoms, phenyl, naphthyl or benzyl that are unsubstituted or substituted in the aromatic nucleus by one to 3 of amino, mono-or di-alkyl amino of one to 5 carbon atoms, alkyl of one to 7 carbon atoms, alkoxy of one to 7 carbon atoms, carboxyl, alkoxycarbonyl of 2 to 7 carbon atoms, acyl or acylamino of one to 5 carbon atoms, or $MeSO_3$— where Ne is alkali metal or

$R_2$ and $R_3$ together with the associated nitrogen atom form a heterocyclic radica of 3 to 12 ring members selected from pyrrolidinyl, piperidyl, pipecolinyl, perhydroazepinyl, heptamethyleneimino, octamethyleneimino, indolinyl, 1,2,3,4-tetrahydroquinolinyl, hexahydrocarbazolyl, morpholinyl, thiomorpholinyl, piperazinyl, N-alkyl piperazinyl where the alkyl group contains one to 4 carbon atoms, pyrazolinyl, or 3-methyl pyrazolinyl

$R_4$ is hydrogen, alkyl of one to 12 carbon atoms, alkoxy of one to 12 carbon atoms, halogen, amino that is unsubstituted or substituted by one or two of the substituents as defined for $R_2$ and $R_3$, or $R_4$ is phenyl, phenoxy, benzyl or benzyloxy that is unsubstituted or substituted in the aromatic nucleus by one of 3 of amino, mono- or di-alkyl amino of one to 5 carbon atoms, lower alkyl, lower alkoxy, carboxyl, alkoxycarbonyl of 2 to 7 carbon atoms, acyl of one to 5 carbon atoms or $MeSO_3$ — where Me is alkali metal

$R_5$ is hydrogen, lower alkyl, lower alkoxy or amino that is unsubstituted or substituted by one or two of the substituents as defined for $R_2$ and $R_3$, including the heterocyclic members,

$R_6$ and $R_7$, each independently is selected from the same group as defined for $R_2$ and $R_3$, including the heterocyclic members thereof;

$(R_8)_m$ represents one to 3 members independently selected from hydrogen, alkyl of one to 7 carbon atoms, alkoxy of one to 7 carbon atoms, halogen, acetamido, amino or mono-or di-alkyl amino of one to 7 carbon atoms.

Of the compounds described above, those wherein $R_1$ $R_5$ and $R_8$ are hydrogen are of particular interest. These compounds have the general formula

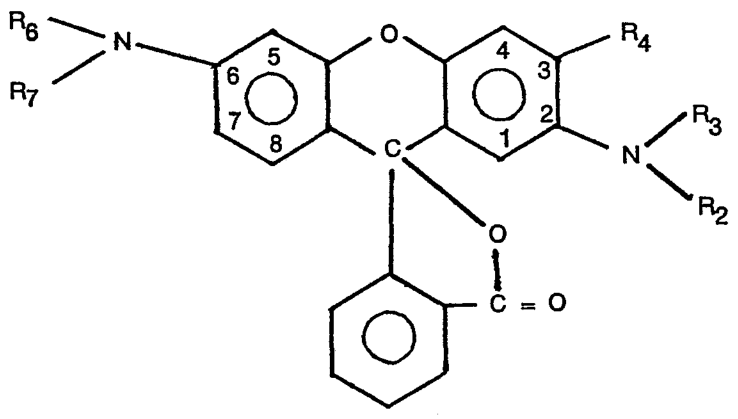

where $R_2$, $R_3$, $R_4$, $R_6$ and $R_7$ are all as previously defined.

Of special interest are the free bases having the preceding formula wherein

$R_2$ is hydrogen, alkyl of one to 7 carbon atoms or acyl of one to 7 carbon atoms

$R_3$ is hydrogen, alkyl of one to 7 carbon atoms, acyl of one to 7 carbon atoms, phenyl, benzyl or naphthyl

or where

$R_2$ and $R_3$ together with the associated nitrogen atom form morpholinyl, piperazinyl, pyrrolidinyl or piperidinyl

$R_4$ is hydrogen, alkyl of one to 7 carbon atoms or alkoxy of one to 7 carbon atoms

$R_6$ and $R_7$ is each alkyl of one to 5 carbon atoms or together with the associated nitrogen form morpholinyl, piperazinyl, pyrrolidinyl or piperidinyl.

Especially preferred are the compounds of formula

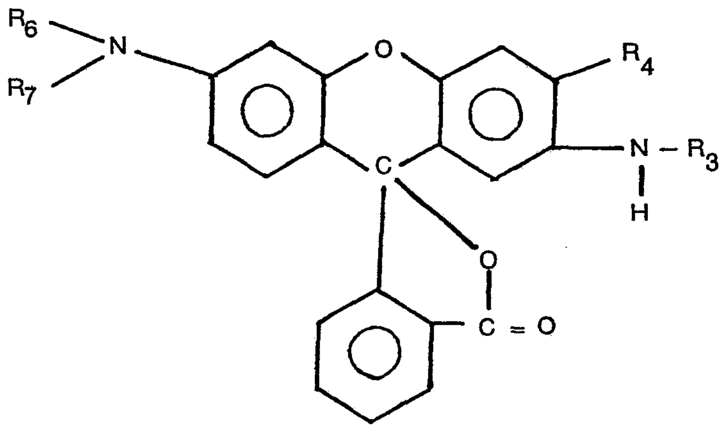

where

$R_3$ is hydrogen or phenyl

$R_4$ is hydrogen, ($C_1$—$C_3$) alkyl or ($C_1$—$C_3$) alkoxy

$R_6$ and $R_7$ is each ($C_1$—$C_3$) alkyl; the compounds found to be notably useful are these where $R_6$ and $R_7$ are both ethyl and where $R_4$ is hydrogen, methyl or methoxy.

Fluoran free bases as described herein are known in the art; they are prepared by reacting a suitable benzophenone with an appropriate phenol derivative in the presence of an acidic condensing agent according to the following general formula

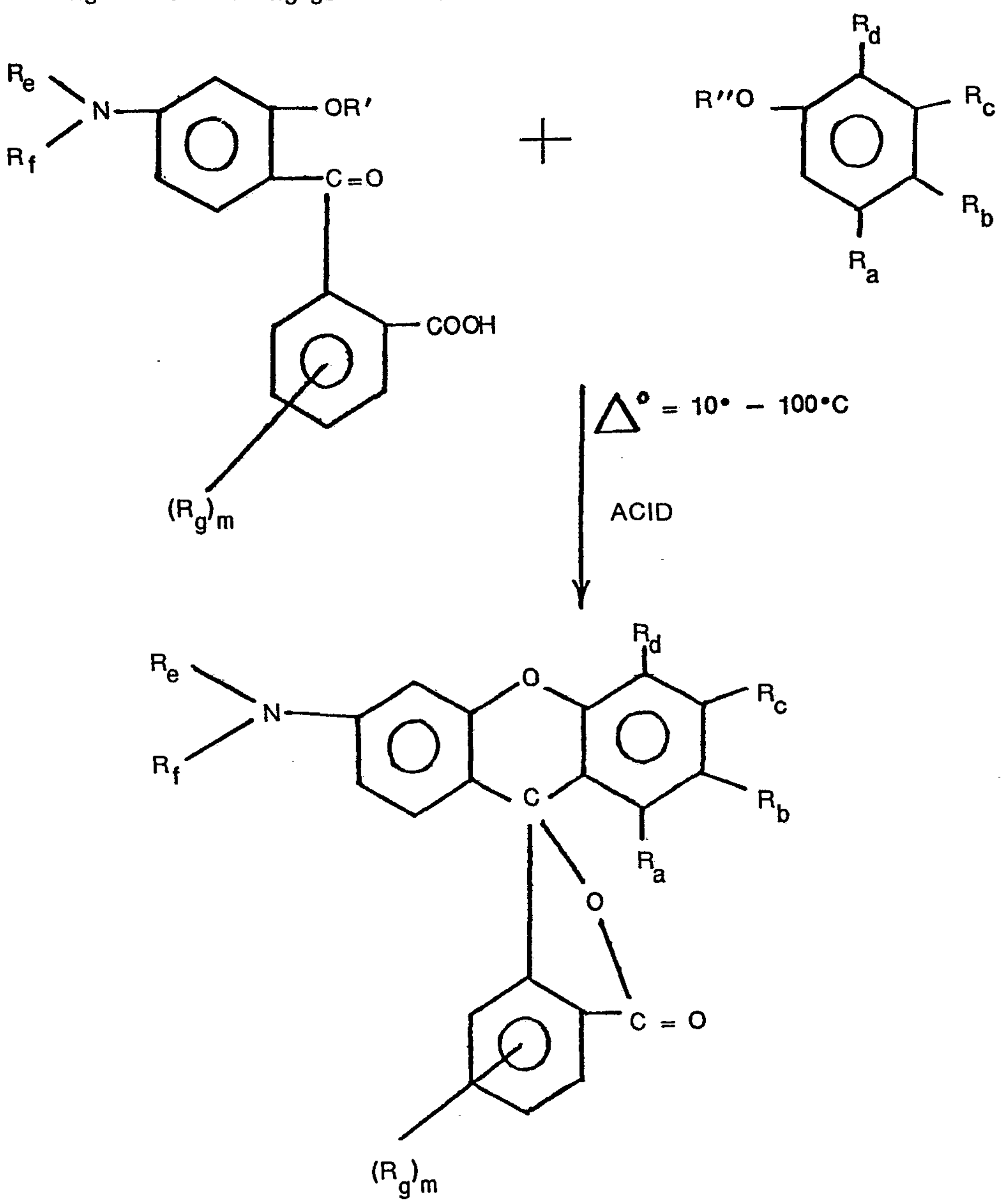

where $R_a$, $R_b$, $R_c$, $R_d$, $R_e$, $R_f$ and $R_g$ are as previously defined and R' and R'' are hydrogen or lower alkyl, preferably hydrogen.

The reaction is typically carried out at 10° to 100°C in the presence of a condensing agent such as acetic anhydride, sulfuric acid, zinc chloride, phosphorus oxychloride and polyphosphoric acid for from 3 to 6 hours; after cooling, the solution is poured into ice water and the product is neutralized with suitable alkali such as an alkali metal hydroxide solution. The crystals are then recovered and purified in known manner, as by recrystallization.

The benzophenone compound can be prepared by reacting a phenol derivative with a phthalic anhydride in an organic solvent such as benzene, toluene, xylene and chlorobenzene, at reflux:

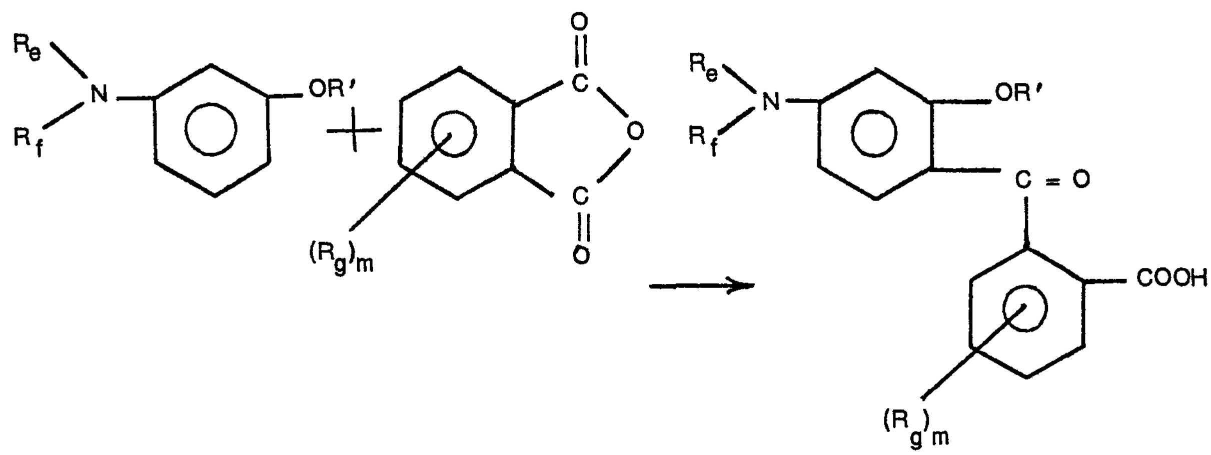

The general art of making fluoran compounds useful herein is described in U.S. Patents No. 4,007,195; 3,997,561; 3,929,831; 3,681,392; 3,514,310; 3,501,331; and in British Patents No. 1,339,316; 1,269,601; 1,211,393; the compound described in these patents are also useful herein.

As indicated, there is contemplated a photosensitive composition that contains at least one component capable of curing, crosslinking or polymerizing upon suitable initiation. In one aspect, this component contains at least one polymerizable ethylenically unsaturated group of structure

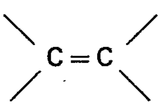

capable of curing, crosslinking or polymerizing under the influence of free radicals. Of these materials, one important class is characterized by the presence of at least one acrylyl or methacrylyl group of formula

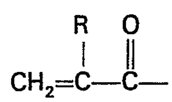

where R is hydrogen or methyl. Monomers, polymers, oligomers and compositions whose functionality is attributable to the presence of acrylate and/or methacrylate groups include acrylic acid, methacrylic acid, acrylamide, methacrylamide, methyl acrylate, methyl methacrylate, ethyl acrylate, ethyl methacrylate, hexyl acrylate, cyclohexyl methacrylate, 2-ethylhexyl acrylate, butoxyethoxyethyl acrylate, bicyclo (2.2.1) hept-2-yl acrylate, dicyclopentenyl acrylate, isodecyl acrylate, ethylene diacrylate, diethylene glycol diacrylate, glycerol diacrylate, glycerol triacrylate, ethylene dimethacrylate; ethylene glycol diacrylate, ethylene glycol dimethacrylate, 1,2,4-butanetriol trimethacrylate, 1,4-benzenediol dimethacrylate, 1,4-cyclohexanediol diacrylate, neopentyl glycol diacrylate, triethylene glycol diacrylate, tetraethyleneglycol diacrylate, pentaerythritol mono-, di-, tri- or tetracrylate or mixtures thereof, pentaerythritol tri- or tetramethacrylate, 1,5-pentanediol dimethacrylate, trimethylol propane mono-, di, or triacrylate or mixtures thereof, 2-phenoxyethyl acrylate, glycidyl acrylate, 2-ethoxyethyl acrylate, 2-methoxythyl acrylate, 2-(N,N-diethylamino) ethyl acrylate, omega-methoxyethyl (undecaoxyethylene) acrylate, omega-trideoxyethyl (undecaoxyethylene) acrylate, trimethoxyallyloxymethyl acrylate, bicyclo (2.2.1) hept-2-en-5-ylmethyl acrylate, bicyclo (2.2.1) hept-2-en-5,6-diyl diacrylate, vinyl acrylate, 2-hydroxypropyl acrylate, 2-hydroxyethyl acrylate, (methyl carbamyl) ethyl acrylate and the bis-acrylates and methacrylates of polyethylene glycols of molecular weight 200—1500.

One group of acrylyl and methacrylyl esters that are particularly useful have the general formula

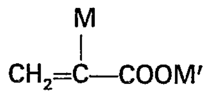 or 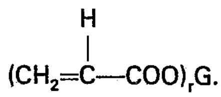

Where the acrylyl compound has the formula

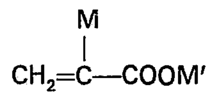

M is H or $CH_3$

M′ is cycloalkyl of 5 to 12 carbon atoms (such as cyclopentyl, dicyclopentyl, methylcyclopentyl, dimethylcyclopentyl, etc.)

cycloalkenyl of 5 to 12 carbon atoms (such as cyclopentenyl, methylcyclopentenyl, dicyclopentenyl, bicyclo (2.2.1) hept-2-en-yl, etc.)

$$—C_pH_{2p}M'' \text{ or } (C_qH_{2q}O)_s\ C_qH_{2q+1},$$

where

*p* is an integer from 1 to 10

*q* is an integer from 2 to 4

*s* is an integer from 0 to 4

M″ is hydrogen, hydroxyl, phenoxy, alkoxy of 1 to 8 carbon atoms; and where the acrylyl compound has the formula

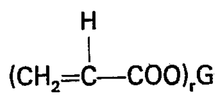

G is a polyvalent alkylene group of formula $—C_xH_{2x-y}—$

in which

*x* is an integer from 2 to 8

*y* is an integer from 0 to 2

(for example, divalent alkylene when y = 0 such as $—C_2H_4—$, $C_3H_6$—iso-$C_3H_6$—, $—C_5H_{10}—$, neo-$C_6H_{12}$ etc; trivalent alkylene when y = 1 such as

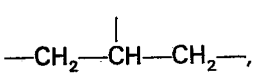, 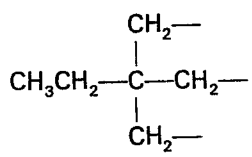 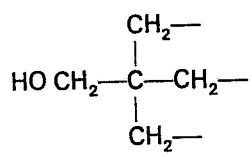

or tetravalent alkylene when y is 2, such as

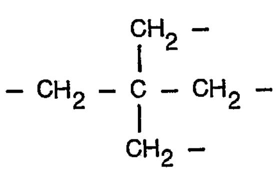 and 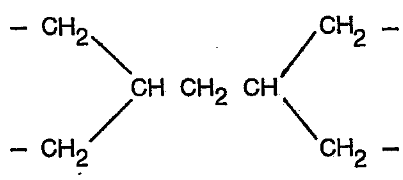

etc.)

or G is a divalent ether or ester group of formula

$$—(C_qH_{2q}O)_t\ C_qH_{2q}— \text{ or } —(C_qH_{2q}COO)_t\ C_qH_{2q}—$$

where *t* is an integer from 1 to 5 and *q* is an integer from 2 to 4 (such as oxyethylene, oxypropylene, oxybutylene, polyoxyethylene, polyoxypropylene, polyoxybutylene, etc.) and *r* is the valence of G and can be 2 to 4.

Triethyleneglycol diacrylate, tetraethylene glycol diacrylate, pentaerythritol triacrylate, trimethylolpropane triacrylate and pentaerythritol tetraacrylate are especially useful.

Acrylate or methacrylate functionality can be incorporated in polymers and oligomers having carboxyl, hydroxyl oxirane or isocyanate groups via reaction with acrylic monomers. Addition reactions of isocyanates to form urethanes or oxiranes to form esters are relatively straightforward. Other methods of acrylation involving condensation or ester interchange reactions are well known.

Thus, there can be used epoxy acrylates obtained by reacting an epoxy resin with acrylic or methacrylic acid or obtained by reacting a hydroxyalkyl acrylate with an anhydride and reacting that product with a diepoxide. Oils, such as soybean oil and linseed oil, can be epoxidized and acrylated.

Polyester resins, for example from a glycol-dibasic acid condensation, can be acrylated by using acrylic or methacrylic acid to complete the esterification. Another method uses the reaction of an anhydride with a mixture of propylene oxide and glycidyl acrylate to obtain an acrylated polyester.

Acrylated alkyd resins are obtained by the reaction of, for example, a triol, dibasic acid, phthalic anhydride and a fatty acid such as hydrogenated castor oil. After reaction is complete acrylation is achieved by direct esterification with acrylic acid.

Urethane acrylates can be prepared directly by the reaction of a diisocyanate with an hydroxyalkyl acrylate, such as 2-hydroxyethyl acrylate. Oligomers are obtained by using an isocyanate-terminated urethane prepolymer for reaction with the hydroxyalkyl acrylate. The urethane prepolymer can be of the polyether or polyester type.

Acrylate functionality can be incorporated in a variety of polymer backbones by incorporating glycidyl methacrylate into the polymer chain and then reacting the pendant oxirane groups with acrylic or methacrylic acid.

Other curable systems are based on unsaturated polyesters such as are obtained from fumaric acid, 4,4′-stilbenedicarboxylic acid, maleic acid, and diallyl ether.

Cinnamate ester groups are also useful, for example in a polyvinyl alcohol-cinnamate ester combination and in conjunction with a variety of polymer materials: polycarbonate cinnamate; polyurethane cinnamate; cinnamyl-modified poly(meth) acrylates; polyepichlorohydrin/cinnamate; poly(cinnamyl methacrylate); epoxy cinnamylidene acetate; carboxycinnamic modified polyesters.

Curable materials are also obtainable from the 2-phenylmaleimido group, allyl ester-maleimide combinations, allthioether polymers, aromatic polysulfone polymer, polysiloxanes, chalcones, sorbic acid derivatives, itaconic acid derivatives and mixtures containing itaconic acid; polyvinyl alcohol, polyvinyl acetate, polyvinyl butyral.

Another polymerizable or curable polymer system is based on the free-radical addition of a thiol to an olefinic double bond:

$$R{-}SH + CH_2{=}CHR' \rightarrow R{-}S{-}CH_2{-}CH_2{-}R'$$

When a polyene and a polythiol are admixed and a stimulus that generates free-radicals is present, rapid curing occurs by simultaneous chain extending and crosslinking reactions.

Other crosslinkable, polymerizable or curable materials include the nitriles such as acrylonitrile and methacrylonitrile; the olefins such as dodecene, styrene, 4-methylstyrene, alphamethylstyrene, cyclopentadiene, dicyclopentadiene, butadiene, 1,4-hexadiene, 4-methyl-1-pentene, bicyclo(2.2.1) hept-2-ene, bicyclo(2.2.1) hept-2,5-diene, cyclohexene; the vinyl halides such as vinyl chloride, vinylidene chloride; the vinyl esters such as vinyl acetate, vinyl butyrate, vinyl benzoate, vinyl butyral, vinyl methacrylate, vinyl crotonate; the vinyl ketones such as vinyl methyl ketone, vinyl phenyl ketone, isopropenyl methyl ketone, divinyl ketone, alpha-chloro-vinyl methyl ketone, vinyl phenyl ketone; acrolein and methacrolein; the vinyl ethers and thioethers such as methyl vinyl ether, ethyl vinyl ether, divinyl ether, isopropyl vinyl ether, the butyl vinyl ethers, 2-ethylhexyl vinyl ether, vinyl 2-chloro-ether, vinyl 2-methoxyethyl ether, n-hexadecyl vinyl ether, vinyl methyl sulfide, vinyl ethylsulfide, divinyl sulfide 1-chloroethyl vinyl sulfide, vinyl octadecyl sulfide, vinyl 2-ethoxyethyl sulfide, vinyl phenyl sulfide, diallyl sulfide; the miscellaneous sulfur and nitrogen containing monomers such as divinyl sulfone, vinyl ethyl sulfone, vinyl sulfonic acid, vinyl ethyl sulfoxide, sodium vinyl sulfonate, vinyl sulfonamide, vinyl pyridine, N-vinyl pyrrollidone, N-vinyl carbazole. Other curable materials are readily apparent to one skilled in the art of polymerization chemistry. The specific compounds mentioned are illustrative only and not all-inclusive. They can be polymerized alone or in mixtures of two or more thereof with the proportions thereof dependent upon the desire of the individual. They can also be blended with polymers.

In another aspect the component that is capable of curing, crosslinking or polymerizing is an epoxy compound that contains one or more 1,2-epoxy groups as follows:

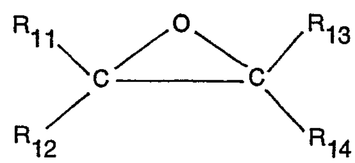

where $R_{11}$, $R_{12}$, $R_{13}$, and $R_{14}$ can be alkyl, aryl, alkoxy, alkenyl and hydrogen.

Thus, there can be used any polymerizable, monomeric or prepolymeric epoxide material or mixture of such epoxide materials containing at least one vicinal epoxide group per molecule. The classic epoxy resin is obtained by the well known reaction of epichlorohydrin and bisphenol A (4,4′-isopropylidenediphenol). The reaction product is believed to have the form of a polyglycidyl ether of bisphenol A (the glycidyl group being more formally referred to as the 2,3-epoxypropyl group) and thus

may be thought of as a polyether derived from the diphenol and glycidol (2,3-epoxy-1-propanol). The structure usually assigned to the resinous product is

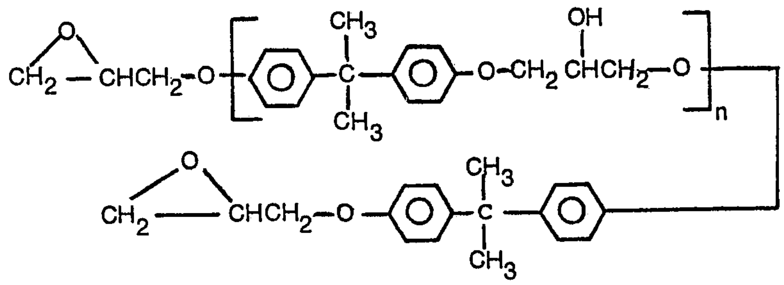

A viscous liquid epoxy resin, average molecular weight about 380, is obtained by reacting the epichlorohydrin in high molecular proportion relative to the bisphenol A, the reaction product containing well over 85 mole percent of the monomeric diglycidyl ether of bisphenol A (n=0), which may be named 2,2-bis [p-(2,3-epoxypropoxy) phenyl] propane, and smaller proportions of polymers in which n is an integer equal to 1,2,3 etc. This product exemplifies epoxide monomers and prepolymers, having a moderate molecular weight preferably of the order of 1,000, or less, which may be cured, crosslinked or otherwise polymerized in accordance with the invention, whereby cleavage of the terminal (vicinal) epoxy or oxirane rings is initiated by the action of the Lewis acid halide released when energy is applied to the photoinitiator, as described below.

Many other epoxide materials are available in polymerizable monomeric or prepolymeric forms. Among these are 1,2-epoxycyclohexane (cyclohexane oxide, also named 7-oxabicyclo [4.1.0] heptane); and vinylcyclohexane dioxide, more specifically named 3-(epoxyethyl)-7-oxabicyclo [4.1.0] heptane or 1,2 - epoxy - 4 - (epoxyethyl) cyclohexane. Ethylene oxide (oxerane,

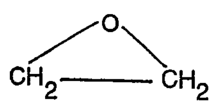

the simplest epoxy ring) and its homologues generally, e.g., propylene oxide (1,2-epoxypropane) and 2,3-epoxybutane, are themselves useful; other useful epoxidic cyclic ethers are the $C_3O$ ring compound trimethylene oxide (oxetane), derivatives thereof such as 3,3-bis(chloromethyl) oxetane (also named 2,2-bis(chloromethyl)-1,3-epoxypropane), and the $C_4O$ ring compound tetrahydrofuran, as examples. Other epoxidized cycloalkenes may be used, a readily available polycyclic diepoxide being dicyclopentadiene dioxide, more specifically identified as 3,4-8,9-diepoxytricyclo ($5.2.1.0^{2,6}$) decane. A suitable polyfunctional cyclic ether is 1,3,5-trioxane.

Glycidyl esters of acrylic acid and of its homologs, methacrylic acid and crotonic acid, are vinyl epoxy monomers of particular interest. Other such monomers are allyl glycidyl ether (1-allyloxy-2,3-epoxypropane) and glycidyl phenyl ether (1,2-epoxy-3-phenoxypropane). Another readily available product is a mixture of ethers of the structure

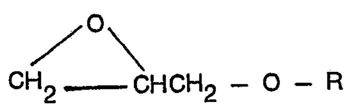

where R is alkyl, that is, glycidyl alkyl ethers. One such mixture contains predominantly glycidyl octyl ether and decyl glycidyl ether; another contains dedecyl glycidyl ether and glycidyl tetradecyl ether. Epoxidized novolak prepolymers likewise may be used, as well as polyolefin (e.g., polyethylene epoxides. The latter are exemplified by epoxidized, low molecular weight by-products of the polymerization of ethylene, which may be separated as mixtures high in 1-alkenes in the range from about 10 to 20 carbon atoms, that is from about 1-decene to about 1-eicosene. Epoxidation then provides mixtures of the corresponding 1,2-epoxyalkanes, examples being mixtures high in the 1,2-epoxy derivatives of alkanes having 11 to 14 carbons, or having 15 to 18 carbons.

Esters of epoxidized cyclic alcohols, or of epoxidized cycloalkanecarboxylic acids, or of both, provide useful epoxide or polyepoxide materials. Thus a suitable ester of epoxidized cyclohexanemethanol and epoxidized cyclohexanecarboxylic acid is the diepoxide (3,4-epoxycyclohexyl) methyl 3,4-epoxycyclohexanecarboxylate, this same ester may be indexed under the name 7-oxabicyclo (4.1.0) hept-3-ylmethyl 7-oxabicyclo (4.1.0) heptane-3-carboxylate. Another suitable diepoxide may be obtained as an ester of a substituted (epoxycycloalkyl) methanol and a dibasic acid, for example bis[(3,4-epoxy-6-methylcyclohexyl) methyl] adipate, which may be named alternatively bis[(4-methyl-7-oxabicyclo [4.1.0] hept-3-yl) methyl] adipate. Diepoxide monomeric materials may be obtained conveniently as bis (epoxyalkyl) ethers of glycols, an example being the diglycidyl ether of 1,4-butanediol, that is, 1,4-bis-(2,3-epoxypropoxy) butane. This diepoxide is related to the diglycidyl ether of bisphenol A, shown above as 2,2-bis[p-(2,3-epoxypropoxy) phenyl] propane.

The component capable of curing, crosslinking or polymerizing upon suitable initiation can be used alone in mixtures and/or in conjunction with one or more preformed polymers.

Among the polymers that can be used one can include, for example, the polyolefins and modified polyolefins, the vinyl polymers, the polyethers, the polyesters, the polylactones, the polyamides, the polyurethanes, the polyureas, the polysiloxanes, the polysulfides, the polysulfones, the polyformaldehydes, the phenolformaldehyde polymers, the natural and modified natural polymers, the heterocyclic polymers.

The term preformed polymer as used herein includes the homopolymers and copolymers and includes the olefin polymers and copolymers such as polyethylene, poly(ethylene/propylene), poly-(ethylene-norbornadiene), poly(ethylene/vinyl acetate), poly(ethylene/vinyl chloride), poly(ethylene/ethyl acrylate), poly(ethylene/acrylonitrile), poly(ethylene/acrylic acid), poly(ethylene/styrene), poly-(ethylene/vinyl ethyl ether), poly(ethylene/vinyl methyl ketone), polybutadiene, poly(butadiene/styrene/acrylonitrile), poly(vinylchloride), poly(vinylidene chloride), poly(vinyl acetate), poly(vinyl methyl ether), poly(vinyl butyral), polystyrene, poly(N-vinylcarbazole), poly(acrylic acid), poly-(methyl acrylate), poly(ethyl acrylate), polyacrylonitrile, polyacrylamide, poly(methacrylic acid), poly(methyl methacrylate), poly(ethyl methacrylate), poly(N,N-dimethyl acrylamide), poly(methacrylamide), polycaprolactone, poly(caprolactone/vinyl chloride), poly(ethylene glycol terephthalate), poly(caprolactam), poly(ethylene oxide), poly(propylene oxide), copolymers of ethylene oxide and propylene oxide with starters containing reactive hydrogen atoms such as the mixed copolymer using ethylene glycol or glycerol or sucrose, etc., as starter, the natural and modified natural polymers such as gutta percha, cellulose, methyl cellulose, starch, silk, wool, and the siloxane polymers and copolymers, the polysulfides and polysulfones, the formaldehyde polymers such as polyformaldehyde, formaldehyde resins such as phenol-formaldehyde, melamineformaldehyde, ureaformaldehyde, aniline-formaldehyde and acetone-formaldehyde.

Selection of the preformed polymer will usually depend on the properties desired of the ultimate, cured product.

The materials utilized as curing, crosslinking or polymerization initiators are radiation-sensitive catalyst precursors that are potentiated by radiation to provide an effective initiator species. Ultraviolet light irradiation is the preferred mode of irradiation.

The known photoinitiators include the azo compounds, organic dyes, sulfur containing compounds, metallic salts and complexes, oximes, amines polynuclear compounds, peroxides, various halogen-containing compounds and organic carbonyl compounds; they can be used alone, in combination with each other or in combination with various synergistic agents.

The aromatic carbonyl compounds are a quite important group of photoinitiators and include benzoin and the benzoin ethers, benzophenone and derivatives of benzophenone, the monoaryl ketones, the diketones, the xanthones, the thioxanthenones, the quinones, and the thioketones.

In the group of benzoin and the benzoin ethers are included such ethers as benzoin methyl ether; benzoin ethyl ether; benzoin allyl ether; benzoin propyl ether; benzoin isopropyl ether; benzoin butyl ether; benzoin isobutyl ether; benzoin sec-butyl ether; benzoin thiophenyl ether; benzoin amyl ether; benzoin hexyl ether; benzoin octyl ether; benzoin 2-ethylhexyl ether; benzoin nonyl ether; benzoin trimethylhexyl ether; benzoin diethyl ether; benzoin phenyl ether; hydroxyethyl benzoin ether; ethylene glycol benzoin ether; 2-chloroethyl benzoin ether; benzoin isobutoxymethyl ether; $\alpha$-alkoxybenzoin ethers; benzoin carbamates.

In the group of benzophenone and derivatives of benzophenone are the 4,4′-di(loweralkyl)benzophenones; 4,4′-di(lower alkoxy) benzophenones; 4,4′-diallylbenzophenone; 4,4′-divinylbenzophenone; 4,4′-di(loweracyl)benzophenone; the alkylamino-benzophenones including 4′(dimethylamino) benzophenone, 4 - hydroxy - 4′ - (dimethylamino)benzophenone; 4 - hydroxy - 4′-(diethylamino)benzophenone; 4 - acryloxy - 4′ - (dimethylamino) benzophenone; 4 - methoxy - 4′-(dimethylamino)benzophenone; 4,4′ - bis(diamino)benzophenone; 4,4′ - bis - (dimethylamino) - benzophenone; 4,4′-bis-(diethylamino)benzophenone; and p-dichloromethylbenzophenone; 4-iodobenzophenone; p - chlorobenzophenone; 4,4′ - bis(bromomethyl)benzophenone; p - hydroxybenzophenone; 2-hydroxy-4-methoxybenzophenone-5-sulfonic acid; p-acryloxybenzophenone; o-methoxybenzophenone; p-methoxybenzophenone; glycidyl ethers of benzophenone; vinyl-substituted benzophenone; 2-isopropenyl-benzophenone; monocarboxyl-substituted benzophenone; polycarboxyl-substituted benzophenone; p-nitrobenzophenone; m-benzophenonesulfonyl chloride; p-p′-bis-(dimethylamino) thiobenzophenone; phenylthiomethylbenzophenone; benzylthiomethylbenzophenone; benzopinacolone; anthrone; benzanthrone, benzanthronesulfonyl chloride; 9-fluorenone; hydroxy-fluorenones; aminofluorenones; 2-bromoethyl-9-fluorenesulfonyl chloride; 2-methylfluorenone; 1-propylfluorenone; 2,7-dimethylfluorenone; 2-vinylfluorenone; 2-benzylfluorenone; 2-ethoxyfluorenone; 2,6-dimethoxyfluorenone; 2,4,5-trimethylfluorenone; 2-acetylfluorenone; 2-chlorofluorenone; 2,7-dichlorofluorenone; dibenzosuberone; 1 - chloromethyl - 6 - chlorosulfonyl - 2 - naphthylphenyl ketone; n-methylacridone; poly(vinyl benzophenone).

The monoaryl ketones include acetophenone, propiophenone, butyrophenone, 3-methylacetophenone, 4-vinylacetophenone, 4-(2-ethylhexyl)-acetophenone, 3-allylacetophenone, 4-vinylacetophenone, 4-hexylpropiophenone, 3-butenylbutyrophenone, 4-tolylacetophenone, 3-benzylacetophenone, 3-xylylacetophenone, 3-methoxyacetophenone, 3-methoxybutyrophenone, 3-decoxyacetophenone, 4-heptoxypropiophenone, 3-bromoacetophenone, 4-chloroacetophenone, 3-chloropropiophenone, 4-iodoacetophenone, 1,4-diacetylbenzene, 1,3-diacetylbenzene, 1,3,4-triacetylbenzene, 1,4-dipropionylbenzene, 1,4-dibutyrobenzene, 3,4-dimethylacetophenone, 1-chloroacetophenone, 1-bromoacetophenone, 1,1'-dichlorobenzophenone, 1-chloroanthraquinone, 1-bromoanthraquinone, 1-chloroxanthane, 1-chloro-thioxanthone, 2-chlorothioxanthane, 2,2'-dipyridylketone, 2-benzolpyridine, 3-benzolpyridine, 4-benzoylpyridine, 3,4-dihexylacetophenone, 3,4-diethylpropiophenone, 3-methyl-4-methoxyacetophenone, chloroalkylphenyl ketones;

$\alpha$-bromoacetophenone; ortho-bromoacetophenone; trichloroacetophenone; trichloroethylidine-acetophenone; 2,2 - dichloro - 4' - tertiary - butylacetophenone; 2,2,2 - trichloro - 4' - tertiary-butylacetophenone; $\alpha$-bromoisobutyrophenone; 2,2 - dibromo - 2(phenylsulfonyl) acetophenone; $\alpha,\alpha$-dialkoxyacetophenone; 2,2-dimethoxyacetophenone; 2,2-dimethoxy-2-phenylacetophenone; 2,2-diethoxyacetophenone; o-methoxyacetophenone; m-methoxyacetophenone; p-methoxyacetophenone; 2-butoxy-2-phenylacetophenone; 2-phenylthio-2-phenylacetophenone; ethyl benzoylacetate; para-aminophenyl ketones; cyclohexylphenyl ketone; pivalophenone; valerophenone; and acetonaphthone.

The diketones include biacetyl; benzil dimethyl ketal; 2,3-dibenzoyl-2-norbornene; benzoylbenzal chloride; 2,2-dibromo-2-(phenylsulfonyl) propanedione; a-naphthil, 2,3-butanedione; benzil; pentanedione; 1-aryl-1,2-propanediones; 2,3-bornanedione; phenylpyruvic acid; 2,4-pentanedione.

The xanthones and thioxanthones include xanthone, 2-methylxanthone, 3-pentylxanthone, 2,6-diethylxanthone, 2-tolylxanthone, 2-methoxyxanthone, 4-methoxyxanthone, 2-acetylxanthone, 2,7-diacetylxanthone, 3-chloroxanthone, 4-bromoxanthone, 2-chloroxanthone, 2,7-dichloroxanthone, 2-chloro-6-nonylxanthone, 2-iodo-5-methoxyxanthone, thioxanthenone, 2-methylthioxanthenone; 3,6-bis(dimethylamino) thioxanthenone; 2-chlorothioxanthenone.

The quinones include p-benzoquinone; o-benzoquinonediazide; anthraquinone; alkylanthraquinones; 2-methylanthraquinone; 2-ethylanthraquinone; 2-tertiary-butylanthraquinone; 2,6-dimethylanthraquinone; 1,5-diethylanthraquinone; 2-vinylanthraquinone; 2-xylylanthraquinone; 2,6-dimethoxyanthraquinone; 2,7-diethoxyanthraquinone; 2-acetylanthraquinone; 2-chloroanthraquinone; 2,4,8-trichloroanthraquinone; 2-bromoanthraquinone; aminoanthraquinone; 1,5-diaminoanthraquinone; piperidinoanthraquinones; anthraquinonesulfonyla chloride; benzanthraquinone; 1,4-naphthoquinone derivatives; phenanthrenequinones; a-chloroanthraquinone.

The thioketones include thiobenzophenone; p,p'-dimethoxythiobenzophenone; p,p'-bis-(dimethylamino) thiobenzophenone.

The azo compounds that are useful include azo compounds, azido compounds and diazonium salts. Azo and azido compounds include 2,2'-azobisisopropane; azobisisobutyronitrile; 2-phenylazobisisobutyronitrile; azobisisobutyramide; azobis (isobutyl acetate); di-(2,4,6-tribromophenyl)-4,4'-azobis (4-cyanovalerate); p-azidobenzaldehyde; b-naphthalenesulfonyl azide; diazomethane; bis(phenylsulfonyl) diazomethane; diazonaphthalenes; diazothioethers; quinone diazides; m,m'-azoxystyrene.

The diazonium salts include those where the diazonium cation

$$(Ar—\overset{+}{N}\equiv N)$$

is p-chlorobenzenediazonium, 2,4-dichlorobenzenediazonium, 2,5-dichlorobenzenediazonium, 2,4,6-trichlorobenzenediazonium, 2,4,6-tribromobenzenediazonium, o-nitrobenzenediazonium, p-nitrobenzenediazonium, 4-nitro-o-toluenediazonium (2-methyl-4-nitrobenzenediazonium), 2-nitro-p-toluenediazonium (4-methyl-2-nitrobenzenediazonium), 6-nitro-2,4-xylenediazonium (2,4-dimethyl-6-nitrobenzenediazonium), 2 - chloro - 4 - (dimethylamino) - 5 - methoxybenzenediazonium, 4 - chloro - 2,5 - dimethoxybenzenediazonium, 2,4',5 - triethoxy - 4 - biphenyldiazonium (2,5 - diethoxy - 4 - (p - ethoxyphenyl)benzenediazonium), 2,5 - dimethoxy - 4' - methyl - 4 - biphenyldiazonium(2,5 - dimethoxy - 4 - (p - tolyl)benzenediazonium), 2,5 - diethoxy - 4 - (phenylthio)-benzenediazonium, 2,5 - diethoxy - 4 - (p - tolylthio)benzenediazonium, p-morpholinobenzenediazonium, 2,5 - dichloro - 4 - morpholinobenzenediazonium, 2,5 - dimethoxy - 4 - morpholinobenzenediazonium, 4 - (dimethylamino) - 1 - naphthalenediazonium, and the anion is a metal halide such as tetrachloroferrate(III), $FeCl_4^-$, hexachlorostannate(IV), $SnCl_6^{-2}$, tetrafluoroborate, $BF_4^-$, hexafluorophosphate, $PF_6^-$, hexafluoroarsenate(V), $AsF_6^-$, hexafluoantimohate(V), $SbF_6^-$, hexachloroantimonate(V), $SbCl_6^-$, pentachlorobismuthate(III), $BiCl_5^{-2}$ ...

Representative diazonium salts include 2,4-dichlorobenzenediazonium tetrachloroferrate(III), p-nitrobenzenediazonium tetrachloroferrate (III), p-morpholinobenzenediazonium tetrachloroferrate (III), 2,4-dichlorobenzenediazonium hexachlorostannate (IV), p-nitrobenzenediazonium hexachlorostannate (IV), 2,4-dichlorobenzenediazonium tetrafluoroborate, p-chlorobenzenediazonium hexafluorophosphate, 2,5-dichlorobenzenediazonium hexafluorophosphate, 2,4,6-trichlorobenzenediazonium hexafluorophosphate, 2,4,6-tribromobenzenediazonium hexafluorophosphate, p-nitrobenzenediazonium hexafluorophosphate, o-nitrobenzenediazonium hexafluorophosphate, 4-nitro-o-toluenediazonium hexafluorophosphate, 2-nitro-p-toluenediazonium hexafluorophosphate, 6-nitro-2,4-xylenediazonium hexafluorophosphate, p-morpholinobenzenediazonium hexafluorophosphate, 4 - chloro - 2,5 - dimethoxybenzene - diazonium hexafluorophosphate, 2,5 - dimethoxy - 4 - morpholino - benzenediazonium hexafluorophosphate, 2 - chloro - 4 - (dimethylamino - 5 - methoxybenzenediazonium hexafluorophosphate, 2,5 - dimethoxy - 4 - (p - tolylthio)benzenediazonium hexafluorophosphate, 2,5 - diethoxy - 4 - (p - tolylthiobenzenediazonium hexafluorophosphate, 2,5 - dimethoxy - 4' - methyl - 4 - biphenyldiazonium hexafluorophosphate, 2,4',5 - triethoxy - 4 - biphenyldiazonium hexafluorophosphate, 4 - (dimethylamino) - 1 - naphthalenediazonium hexafluorophosphate, p - nitrobenzenediazonium hexafluoroarsenate (V), p - morpholinobenzenediazonium hexafluoroarsenate (V), 2,5 - dichlorobenzenediazonium hexafluoroantimonate (V), p - nitrobenzenediazonium hexafluoroantimonate (V), p - morpholinobenzenediazonium hexachloroantimonate (V), 2,4 - dichlorobenzenediazonium hexachloroantimonate (V), 2,4 - dichlorobenzenediazonium pentachlorobismuthate III. o - nitrobenzenediazonium pentachlorobismuthate III.

The sulfur containing compounds include n-dodecyl mercaptan; 2-mercaptobenzimidazole; diphenyl sulfide; cyclohexylphenylsulfide; benzoin thioethers; benzoin thiophenyl ether; phenylthiomethylbenzophenone; s,s'-diphenyl dithiocarbonate; calcium sulfide; metallic tellurides; diaryl disulfides; diphenyl disulfide; dithiolane; dibenzyldisulfide; dixanthate; benzothiazoles; 2,2'-dithiobis(benzothiazole); 2-mercaptobenzothiazole; thiazolines; thiocarbamates; dithiocarbamic esters; dithiocarbamic anhydrides; thiurams; toluene sulfonic acid; sulfonyl chlorides; m-(chlorosulfonyl)benzyl chloride; naphthalenesulfonyl chloride 2-bromoethyl-9-fluorenonsulfonyl chloride; 2,2-dibromo-2(phenylsulfonyl)acetophenone; 2,2-dibromo-2(phenylsulfonyl) propanedione; benzophenonesulfonyl chloride; diphenyl disulfone.

The oximes include o-acyloximes; 1-phenyl-1, 2-propanedione-2-o-benzoyl oxime; oxido-oxazole; benzylmonooxime; biacetyl monooxime phenylcarbamate.

The halogenated organic compounds include chloroform; bromoform; iodoform; carbon tetrachloride; carbon tetrabromide; ethylene dichloride; trichloroethylene; trichloroethane; bromo-trichloroethane; vinyl bromide; 1,2-dibromotetrafluoroethane; iodoethane; diacyclhalomethane; hexachloroethane; tetrachloroethane; hexachlorobenzene; o-dichlorobenzene.

The polynuclear compounds include naphthalene; halogenated napththalenes; 2,3,6-trimethyl-naphthalene; a-naphthol; 1-aminonaphthalene; 1-methoxynaphthalene; 2,3-diphenylquinoxaline; anthracene; aminoanthraquinone; phenanthrene; naphthacene; fluorene; 9-fluorenone; stilbene; trinitrofiuorenone; polynuclear quinones.

The metal salts and complexes include zinc chloride; zinc bromide; zinc sulfide; ferric chloride; chromium chloride; nickel chloride; tin chloride; stannous chloride; vanadium tetrachloride; vanadium oxychloride, vanadium naphthenate; aluminium chloride; aluminium bromide; aluminium iodide; silver halides; gold salts; sodium chloraurate; mercury salts; mercury iodosulfide; titanium tetrachloride; cadmium sulfide; boron trifluoride; boron trichloride; ceric salts; thallium salts; uranyl salts; cobalt octoate; cobalt naphthenate; magnesium oxide; zinc oxide; titanium dioxide; alumina; cupric oxide; chromium oxide; silver oxide compounds; metal chelates; metal amine complexes; cobalt EDTA complexes; iron EDTA complexes; metal acetylacetonate; manganese tris (acetylacetonate); metal salt-saccharide complexes; metal oxalato complexes; p-benzoquinone complexes; copper (I) complexes; manganese carbonyl; rhenium carbonyl; osmium carbonyl; iron carbonyls; metal thiocarbonyls; trialkylaluminum; diethylaluminum chloride; triphenylmethyldiethyltitanium chloride; bis(2-chloroethyl) diethyltitanium; tetrabenzyltitanium, ferrocene; cyclopentadienylmanganese tricarbonyls.

The peroxides include hydrogen peroxide; benzoyl peroxide; tertiary-butyl peroctoate; t-butyl a-cyanoperacetate; t-butyl hydroperoxide; di-t-butyl peroxide; cumene hydroperoxide; a-cumyl peroxide; ergosterol peroxide; fluorenone hydroperoxide; acetyl peroxide.

The imidazoles include benzimidazoles; 2-methyl benzimidazole; 2-mercaptobenzimidazole; triphenyl-imidazolyl dimers.

Ammonium salts include bipyridylium salt; benzyltrimethylammonium chloride.

Organic dyes that are useful include acridines; benzacridine; benzidines; b-carotene; chlorophyll; crystal violet; eosin; erythrosine, fluorescein; indanthrene yellow; irgazin yellow; methyl violet; methylene blue; pyronine-G; rhodamines; riboflavin; rose bengal; thiazine dyes; thionine; xanthene dyes; xanthophyll; iodoeosine.

Where the component capable of curing, crosslinking or polymerization contains an ethylenically unsaturated group, and notably an acrylyl or methacrylyl group, the preferred free radical photoinitiators are the benzoin ethers, benzophenone, the alkylamino benzophenones, the xanthones, the thioxanthones as well as combinations of said photoinitiators with each other and with chain transfer agents such as organic amines.

Where said component is an epoxide, the preferred photoinitiator is a diazonium salt; since this type of photoinitiator generates a Lewis acid, no separate activator is required.

Prior to describing activators within the scope of this invention, it must be understood that the fluoran compounds described herein are converted to dark colored products by contact with an acidic substance. The acidic materials are those falling within the definition of a Lewis acid, that is, an electron acceptor. Thus, the activators useful herein will either generate a Lewis acid or will facilitate the production of a Lewis acid from some other source.

The ability of a diazonium metal halide salt to liberate a Lewis acid under the influence of actinic radiation has been previously discussed; these diazonium salts represent one group of compounds useful as activators.

A second class of materials useful as activators is the combination of a proton donor and a halogenated compound in the presence of a free radical type photoinitiator. While not wishing to be bound to any theoretical explanation for the chemistry of this activator system, the perceived results may be explained as follows. The proton donor (PD), whether by the effect of the free radical initiator (in) or otherwise, provides protons that are effective to convert the fluoran compound to the dark colored reaction product. The halogenated compound, functioning as an electron sink, pushes the reaction to the right, encouraging proton formation:

$$In \xrightarrow{h\nu} In^{*} \xrightarrow{PD} In^{\bullet -} + PD^{\bullet +}$$

$$PD^{\bullet +} \longrightarrow PD^{\bullet} + H^{\oplus}$$

$$In^{\bullet -} + RX \longrightarrow In + R\cdot + X^{-}$$

The proton donor can be an amine, an arsine or a phosphine and can be represented by the formula

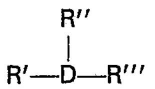

where D is N, As or P

R′ and R″, each independently is hydrogen, linear or branched alkyl of from 1 to about 12 carbon atoms, linear or branched alkenyl of from 2 to about 12 carbon atoms, cycloalkyl of from 3 to about 10 ring carbon atoms, cycloalkenyl of from 3 to about 10 ring carbon atoms, aryl of from 6 to 12 ring carbon atoms, alkaryl of from 6 to about 12 ring carbon atoms, aralkyl of from 6 to about 12 ring carbon atoms, R‴ has the same meaning as R′ and R″ except that it cannot be hydrogen and cannot be aryl when both R′ and R″ are aryl; the aryl groups can be unsubstituted or substituted by one or more of amino, mono- or di-(lower alkyl) amino loweralkylcarbonyl, loweralkoxycarbonyl, loweralkylcarbonyloxy, phenylcarbonyl or aminophenylenecarbonyl where the amino group is unsubstituted or substituted by lower alkyl.

Additionally, R″ and R‴ together with D can form a heterocyclic group. Thus R″ and R‴ together can be divalent alkylene of 2 to 12 carbon atoms, divalent alkenylene of 3 to 12 carbon atoms, divalent alkadienylene of 5 to 10 carbon atoms, divalent alkatrienylene of from 5 to 10 carbon atoms, divalent alkyleneoxyalkylene having a total of from 4 to 12 carbon atoms or divalent alkyleneaminoalkylene having a total of from 4 to 12 carbon atoms.

Because of ready availability, lower toxicity and stability, the amines are preferred; representative specific organic amines include methylamine, dimethylamine, trimethylamine, diethylamine, triethylamine, propylamine, isopropylamine, diisopropylamine, triisopropylamine, butylamine, tributylamine, t-butylamine, 2-methylbutylamine, N-methyl-N-butylamine, di-2-methylbutylamine, trihexylamine, tri-2-ethylhexylamine, dodecylamine, tridodecyclamine, tri-2-chloroethylamine, di-2-bromoethylamine, methanolamine, ethanolamine, diethanolamine, triethanolamine, N-methyldiethanolamine, N,N-dimethylethanolamine, N-methyldiethanolamine, isopropanolamine, propanolamine, diisopropanolamine, triisopropanolamine, N-butylethanolamine, dihexanolamine, 2-methoxyethylamine, di-2-ethoxyethylamine, tri-2-ethoxyethylamine, 2-hydroxyethyldiisopropylamine, 2-aminoethylethanolamine, allylamine, butenylamine, dihexadienylamine, cyclohexylamine tricyclohexylamine, trimethylcyclohexylamine, bis-methylcyclopentylamine, tricyclohexenylamine, tricyclohexadienylamine, tricyclopentadienylamine, N-methyl-N-cyclohexylamine, N-2-ethyl-hexyl-N-cyclohexylamine, diphenylamine, phenyldimethylamine, p-acetylphenyldimethylamine, p-caprylphenyl dimethylamine, methylphenylamine, ditolylamine, p-dimethylaminophenyl acetate p-dimethylaminophenyl valerate, trixylylamine, tribenzylamine, triphenethylamine, benzyldimethylamine, benzyldihexylamine, ethyl dimethylaminobenzoate, heptyl dimethylaminobenzoate, tris-chlorophenethylenimine, N-methylethylenimine, N-cyclohexylethylenimine, piperidine, N-ethylpiperidine, 2-methylpiperidine, 1,2,3,4-tetrahydropyridine, 1,2-dihydropyridine, 2-, 3- and 4- picoline, morpholine, N-methylmorpholine, N-2-hydroxyethylmorpholine, N-2-ethoxyethylmorpholine, piperazine, N-methylpiperazine, N,N′-dimethylpiperazine, 2,2-dimethyl- 1,3-bis [3-(N-morpholinyl)-propionyloxyl] propane, 1,5-bis [3-(N-morpholinyl)-propionyloxy diethyl] ether, N,N-dimethylbenzylamine, ethyldiethanolamine; triethanolamine; p-nitroaniline; n - acetyl - 4 - nitro - 1 - naphthylamine; aminoanthraquinone.

A preferred group of amines are the p-aminophenyl ketones of general formula

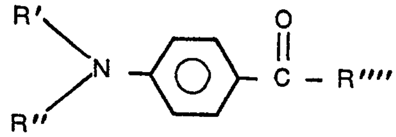

Where R′ and R″ are alkyl of one to 4 carbon atoms and R'''' is alkyl of one to 12 carbon atoms, alkoxy of one to 12 carbon atoms, phenyl, loweralkyliminophenylene or di(loweralkyl) aminophenylene.

Representative compounds include p-(dimethylamino) acetophenone; p-(dimethylamino) propiophenone; p-(dimethylamino) butyrophenone; p-(dimethylamino) valerophenone; p-(dimethylamino) myristylphenone; the p-(diloweralkylamino) benzoic acid esters such as p-(dimethylamino) benzoic acid ethyl ester; p-(dimethylamino) benzoic acid butyl ester; p-(dimethylamino) benzoic acid lauryl ester; p-(dimethylamino) benzoic acid myristyl ester; 4-dimethylaminobenzophenone; 4-dimethylamino-4′-propylaminobenzophenone; and 4,4′ bis(dimethylamino) benzophenone.

One class of useful halogenated compounds comprises the halogenated hydrocarbons; these can be aromatic, aliphatic, alicyclic, and combinations thereof. In addition to halogen, these compounds can be substituted by oxygen, amine, amide, hydroxyl, nitrile or phosphate. The hydrocarbyl rings or chains can be interrupted by ether (—O—), ester

$(-\overset{O}{\overset{\|}{C}}-O-)$, carbonyl $(-\overset{O}{\overset{\|}{C}}-)$ or amide $(-\overset{O}{\overset{\|}{C}}-\overset{H}{\overset{|}{N}}-)$.

Halogenated aliphatic compounds include the halogenated alkanes and alkenes of 1 to about 8 carbon atoms, illustrated by such alkanes as carbon tetrachloride; carbon tetrabromide; bromoform iodoform; iodoethane; 1,2-diiodoethane; 2-bromo-1-iodoethane; 1,2-dibromoethane; 1-bromo-1-chloroethane; 1,1,2,2-tetrabromoethane; hexachloroethane; 1,1,1-trichloroethane; 1,1 - bis - (p - chlorophenyl) - 2,2,2 - trichloroethan; 1,2 - dibromo - 1,1,2 - trichloroethane; 1-bromo-3-chloropropane; 1,2-dibromo-3-chloropropane; 1,2,3-tribromopropane; 1-bromobutane; 2-bromobutane; 1,4-dibromobutane; 1-bromo-4-chlorobutane; 1,4-diiodobutane; 1,2,3,4-tetrabromobutane; pentamethylene bromide; hexamethylene bromide, etc.; the halogenated alkanols of 2 to about 8 carbon atoms such as 2-bromoethanol;

2,2,2-trichloroethanol; tribromoethanol; 2,3-dibromopropanol; 1,3-dichloro-2-propanol; 1,3-diiodo-2-propanol; 1,1,1-trichloro-2-propanol; di(iodohexamethylene) amino-isopropanol; 1,1,1 - trichloro - 2 - methyl - 2 - propanol; tribromo - t - butyl alcohol; 2,2,3-trichlorobutane-1,4-diol; halogenated cycloaliphatic compounds such as tetrachlorocyclopropene; dibromocyclopentane; hexachlorocyclopentadiene; dibromocyclohexane; chlorendic anhydride; the halogenated aliphatic carbonyl containing compounds of 2 to about 8 carbon atoms, which are illustrated by 1,1-dichloroacetone; 1,3-dichloroacetone; hexachloroacetone; hexabromoacetone; pentachloroacetone; 1,1,3,3-tetrachloroacetone; 1,1,1-trichloroacetone; 3,4-dibromobutanone-2; 1,4-dichlorobutanone-2; 1,2,5-trichloropentanone-2; dibromocyclohexanone; the halogenated ethers of 3 to about 8 carbon atoms are illustrated by 2-bromoethyl methyl ether; 2-bromoethyl ethyl ether; di-(2-bromoethyl)ether; di-(2-chloroethyl)ether; di-(2-chloroethyl)ether; 1,2-dichloroethyl ethyl ether.

The amide and ester compounds are conveniently discussed in connection with the halogenated mono or dicarboxylic acids of 2 to 8 carbon atoms, as the esters and amides thereof. These compounds will have the general formula

$$X_a-(A)-(\overset{O}{\overset{\|}{C}}-G)_b$$

where X is Cl, Br or I

a is an integer from 1 to 4

A is alkyl or alkenyl of 1 to 7 carbon atoms

G is —OA′ or $-\overset{H}{N}-A''$

where A′ is alkyl or haloalkyl of 1 to 15 carbon atoms where halo is Cl, Br or I; A″ is hydrogen, alkyl or haloalkyl of 1 to 4 carbon atoms where halo is Cl, Br or I;

b is 1 or 2.

In providing that *a* is an integer from 1 to 4, it is noted that the obviously chemically impossible structures such as tetrachloroacetamide and β,β,β-trichlorobutyramide are excluded. Thus, the provision that *a* is an integer from 1 to 4 is intended to be a shorthand way of indicating that *a* is an integer from

1 to 3 when A has one carbon atom and that *a* is an integer from 1 to 4 when A has 2 to 7 carbon atoms, provided that no carbon atom bound to two other carbon atoms contains more than two halogen atoms and no carbon atom bound to one carbon atom contains more than 3 halogen atoms.

A can be methyl, ethyl, propyl, butyl, amyl, hexyl, heptyl, including the isomers thereof, vinyl, allyl, isopropenyl, butenyl, isobutenyl, or pentenyl.

The acids are exemplified by chloracetic; bromoacetic; iodoacetic; dichloroacetic; trichloroacetic; tribromoacetic; 2-chloropropionic; 3-bromopropionic; 2-bromoisopropionic; 2,3-dibromopropionic; 3-iodopropionic; $\alpha$-bromobutyric; $\alpha$-bromoisobutyric; 3,4-dibromobutyric; etc.; bromosuccinic; bromomaleic and dibromomaleic.

The ester can be the ester of a halogenated carboxylic acid as described and exemplifed above, the halogenated ester of a carboxylic acid or the halogenated ester of a halogenated carboxylic acid. The esters are exemplified by bromoethyl acetate; ethyl trichloroacetate; trichloroethyl trichloroacetate; isooctyl trichloroacetate; isotridecyl trichloroacetate; homopolymers and copolymers of 2,3-dibromopropyl acrylate; trichloroethyl dibromopropionate; iodoethyl dibromobutyrate; ethyl $\alpha,\beta$-dichloroacrylate; ethyl, 3,4-dibromovinylacetate, etc.

The amides are exemplified by chloroacetamide; bromoacetamide; iodoacetamide; dichloroacetamide; trichloroacetamide; tribromoacetamide; trichloroethyl trichloroacetamide; 3-bromopropionamide; 2-bromoisopropionamide; 2,3-dibromopropionamide; 2,2,2-trichloropropionamide; 2-bromobutyramide; 2-bromoisobutyramide and N-chlorosuccinimide, N-bromosuccinimide, 2,3-dibromosuccinimide, 2,3,4,5-tetraiodopyrrole and N-[1,1-bis-(p-chlorophenyl)-2,2,2-trichloroethyl] acetamide.

Preferred amides are those melting in the range 90° to 150°C such as

| Compound | Melting Point °C |
|---|---|
| $BrCH_2CONH_2$ | 91° |
| $ClCH_2CONH_2$ | 121° |
| $Cl_2CH\ CONH_2$ | 99.4° |
| $I\ CH_2CONH_2$ | 95° |
| $Br_3\ C\ CONH_2$ | 121.5° |
| $Cl_3\ C\ CONH_2$ | 142° |
| $Br\ CH_2CH_2CONH_2$ | 111° |
| $(CH_3)_2\ C\ Br\ CONH_2$ | 148° |
| $CH_3CH_2CH\ Br\ CONH_2$ | 112.5° |
| $(CH_3)_2\ CHCH\ Br\ CONH_2$ | 133° |

Other halogenated aliphatic hydrocarbyl compounds include chlorinated rubbers such as the Parlons (Hercules Powder Co.); poly (vinyl chloride); copolymers of vinyl chloride and vinyl isobutyl ether such as Vinoflex MP-400 (BASF Colors & Chemicals, Inc.); chlorinated aliphatic waxes such as Chlorowax 70 (Diamond Alkali, Inc.); perchlorocyclodecane such as Declorane+ (Hooker Chemical Co.); chlorinated paraffins such as Clorafin 40 (Hooker Chemical Co.) and Unichlor-70B (Neville Chemical Co.); and 2,3 - bis - (bromoethyl) - 1,4 - dibromo - 2 - butene.

The aromatic hydrocarbyl compounds include the polyhalo benzenes such as the di-, tri-, tetra-, penta- and hexachlorobenzenes and bromobenzenes; the di-, tri-, and tetra- chloroxylenes and bromoxylenes, di- and tri- chloroaniline and bromoaniline; the polyhalogenated polyphenyl compounds such as the Araclor plasticizers (Monsanto Chemical Co.) which in general are polychlorinated diphenyls, polychlorinated triphenyls and mixtures thereof; hexabromobiphenyl, tetrabromobisphenol A etc.

While it is apparent that both aliphatic and aromatic halides can be successfully employed, it is preferred to use the aliphatic halides; of the aliphatic halides, it is generally preferred to use those halides having more than one halogen atom bound to the same carbon atom, and it is particularly preferred to use those halogenated aliphatic compounds where there are three halogen atoms bound to a single carbon atom. The halogen containing material can be present as single compound or as a mixture of halogen containing compounds.

Where the compositions are to be prepared and stored for periods of time, stability becomes a

factor. For that reason, the volatile materials such as carbon tetrabromide, iodoform, ethyl iodide and 2,2,2-trichloroethanol, which work quite well are contraindicated in systems that will be stored for appreciable periods. These compounds are further undesirable because of the odor due to their volatility. Thus, the halogenated compounds that are nonvolatile liquids or solids are preferred.

From the foregoing, it is apparent that in one aspect the invention relates to a phototropic photosensitive composition comprising

a. an epoxide
b. a fluoran colorformer
c. a latent Lewis acid generator

In another aspect, the invention relates to a phototropic photosensitive composition comprising

a. an ethylenically unsaturated component
b. a photoinitiator
c. a fluoran colorformer
d. a latent Lewis acid source.

In one embodiment of this aspect, the composition comprises

a. an ethylenically unsaturated component capable of free radical initiated curing, crosslinking or polymerization;
b. a free radical generator
c. a fluoran colorformer
d.1. a hydrogen donor
2. a halogenated compound

In another embodiment of this aspect, the composition comprises

a. an ethylenically unsaturated component capable of free radical initiated curing, crosslinking or polymerization;
b. a free radical generator
c. a fluoran colorformer
d. a diazonium metal halide salt

In still another embodiment of this aspect the composition comprises

a. an ethylenically unsaturated component capable of free radical initiated curing, crosslinking or polymerization;
b. a free radical generator
c. a fluoran colorformer
d.1. a hydrogen donor
2. a halogenated compound
3. a diazonium metal halide salt

Where the free radical generator is a combination that includes a hydrogen donor, such as benzophenone, and an amine, such as an alkylamino benzophenone, another hydrogen donor need not be added. Thus an amine, if present, can perform two functions; as a chain transfer agent and as a proton donor in connection with activation of the fluoran colorformer.

In the preferred embodiments the photosensitive phototropic composition comprises

a. an acrylyl or methacrylyl compound
b. a photoinitiator
c. a fluoran colorformer
d.1. an amine
2. a halogenated compound

and the particularly preferred embodiments are those where the photoinitiator is one or more of a benzoin ether, benzophenone, a derivative of benzophenone, a monoaryl ketone, a xanthone, a thioxanthone, or a quinone and the halogenated compound is an ester or amide of a halogenated carboxylic acid of 2 to 8 carbon atoms and the fluoran is a 2-amino fluoran. Thus in the particularly preferred embodiments the compositions comprise

a. an acrylyl or methacrylyl compound

b. a benzoin ether, benzophenone, a lower alkylamino benzophenone, a monoaryl ketone, a xanthone, a thioxanthone, a quinone or mixture thereof

c. a 2-amino fluoran colorformer

d.1. a tertiary amine

2. an amide or ester of a halogenated mono or dicarboxylic acid of 2 to 8 carbon atoms.

The compositions of the present invention may be used in relatively thick layers or may be cast as thin films having thicknesses of from 0.25 to 5 mils or even more. When prepared in the form of an assembly comprising a support, composition and transparent sheet, i.e., dry film photoresist, the composition will generally be from 0.5 to 5 mils thick. Suitable base or support materials include metals such as steel, aluminium and copper in the form of plates, sheets and foils; film-forming synthetic resins or high polymers such as addition polymers and copolymers of vinyl chloride, vinylidine chloride, vinyl acetate, acrylonitrile, ethylene, propylene, etc.; and condensation polymers such as polyethylene terephthalate and polyamides and thermoset composites such as fiberglass-epoxy and paper-phenolic laminates.

A typical useful dry film resist will contain:

| Component | Broad Range (weight %) | Preferred Range (weight %) |
|---|---|---|
| Preformed polymer binder | 40—68.79% | 50—67,8% |
| Polymerizable, curable or crosslinkable component | 30—50% | 30—40% |
| Photoinitiator(s) | 1—10% | 1—5% |
| Fluoran Colorformer | 0.01—2% | 0.5—1.5% |
| Halogenated compound | 0.1—5% | 0.5—2% |
| Amine | 0.1—10% | 0.2—5% |

The dry film phototropic photosensitive composition can additionally contain other conventional components such as thermal polymerization inhibitors, antioxidants, adhesion promoters and the like.

In use, the photopolymerizable dry film is exposed to a source of actinic radiation which may be through a half-tone image or a process transparency; e.g., a process negative or positive, stencil or a mask. Exposure may also be through a continuous tone, negative or positive image. The exposure can be by the contact or projection method, with or without a cover sheet over the photopolymerizable layer or by projection using a cover sheet. These procedures are well known to those skilled in the art. The photoresist compositions are generally used in conjunction with ultraviolet light and the radiation source should furnish an effective amount of this radiation; point or broad radiation sources are effective. Such sources include carbon arcs, mercury-vapor arcs, fluorescent lamps with ultraviolet radiation emitting phosphors, argo glow lamps, electronic flash units and photographic flood lamp. Of these, the mercury vapor arcs, particularly the sun lamps, are most suitable.

The dry film photoresist compositions after exposure can be developed in known manner, for example by impingement of spray jets, with agitated immersion, brushing or scrubbing to desirable images with an organic solvent or mixture thereof capable of washing away the unexposed portions of the resist film. Useful solvents include cellosolve acetate, ethyl acetate, methyl ethyl ketone, acetone, trichloroethylene, carbon tetrachloride, tetrachloroethylene, the alkanols of one to four carbon atoms, butyl cellosolve, chlorobenzene and dimethylformamide. Where the resist has been formulated to be developed by aqueous alkali, solutions of sodium carbonate, sodium hydroxide, trisodium phosphate and the like can be used either alone or in admixture with each other or with one or more solvents.

The phototropic compositions are also useful in ultraviolet-curable coating and printing compositions. One advantage that attends such compositions formulated with the phototropic dye systems is that thicker coatings can be employed than was previously the case since actinic light can penetrate through to the bottom of the coating before the color of the composition has intensified. Since color can now be obtained without pigments and the like which interfere with the penetration of actinic light, thicker, more resistant coatings are obtainable.

The coating and printing compositions can be based on an epoxide or on an ethylenically unsaturated component, both as previously described. Generally, these compositions will contain from about .1 to about 2% of fluoran compound, from about .1 to about 5% of halogenated compound (whether diazonium metal halide salt or halogenated compound as described); where the activator is an amine-halogenated hydrocarbon, the amine will be present in an amount of from 0.1 to 10%; the compositions will generally contain from about 1 to 10% by weight of photoinitiator. The balance of the compositions will be monomeric (including reactive oligomers) compounds, polymeric binders,

plasticizers, adhesion promoters, antioxidants, fillers, thixotropic agents and leveling agents. Pigments can be added if desired.

These compositions can be applied by screen or other printing techniques or by brushing, roller coating, knife coating, curtain coating, etc.

While the epoxide and ethylenically unsaturated compounds previously described are useful, the acrylyl and methacrylyl compounds, notably the acrylyl oligomers and esters as described above, are particularly useful.

One useful class of oligomers is obtained by reacting an organic polyether or polyester polyol with a diisocyanate to provide an isocyanate-terminated prepolymer. This product can be reacted with an unsaturated alcohol, such as a hydroxy alkyl acrylate to provide, either alone or in combination with other unsaturated monomers, a material that will polymerize under the influence of free radicals to form a hard, tough, adherent film.

In a variation of the foregoing, a polymercaptoester such as trimethylolpropane-tris-(thioglycolate); trimethylolpropane tris-(mercaptopropionate); pentaerythritol tetrakis-(thioglycolate); pentaerythritol tetrakis-(mercaptopropionate); and the like are reacted with a diisocyanate to provide a polythiourethane intermediate which can be reacted with an unsaturated alcohol, such as a hydroxy acrylate to provide either alone or in combination with other unsaturated monomers, a free radical polymerizable material having excellent film properties after crosslinking.

Another illustration of a useful oligomer is an acrylate-capped polycaprolactone polyurethane, obtained by reacting a hydroxy-terminated polycaprolactone with a diisocyanate and thereafter reacting the isocyanate-terminated intermediate with an unsaturated alcohol such as a hydroxyalkyl acrylate.

Still another useful class of oligomers is obtained by reacting an epoxy resin with acrylic acid to obtain an epoxy diacrylate. For example, an epichlorohydrin/bisphenol A-type epoxy resin can be reacted with a stoichiometric amount of acrylic acid. Such products are available commercially as under the trademark "Epocryl" from Shell Chemical Company. Such materials can be combined with a variety of acrylic esters including neopentyl glycol diacrylate, hydroxyethyl acrylate and dicyclopentenyl acrylate and other unsaturated esters of polyols including such esters of methylene carboxylic acid such as, ethylene glycol diacrylate; diethylene glycol diacrylate; glycerol diacrylate; glycerol triacrylate; ethylene glycol dimethacrylate; 1,3-propylene glycol dimethacrylate; 1,2,4-butanetriol trimethacrylate; 1,4-benzenediol dimethacrylate; pentaerythritol tetramethacrylate; 1,3-propanediol diacrylate; 1,6-hexanediol diacrylate; the bis-acrylates and methacrylates polyethylene glycols of molecular weight 200—500; trimethylolpropane triacrylate; pentaerythritol triacrylate; and other ethylenically unsaturated compounds, to polymerize under the influence of free radicals to form films of excellent adhesion and toughness.

Another composition comprises a combination of a terminally unsaturated urethane composition (polyene) and a polythiol which are polymerizable under the influence of free radicals generated by the action of actinic light on a photoinitiator.

The coating and printing ink compositions will contain a predominant amount of film-forming materials and photosensitizer and a relatively minor amount of fluoran compound halogen compound and amine. For example, a typical composition will contain from 15 to 70% by weight of an ethylenically unsaturated compound as described above, 10—50% of one or more unsaturated monomers or of a preformed polymeric binder, 0.1 to 10% by weight of a photoinitiator; 0.01 to 2% by weight of fluoran compound as described above, 0.1 to about 5% of halogen containing compound and 0.1 to 10% of amine. A more narrow range is from about 40 to about 55% by weight of ethylenically unsaturated compound, from 30—45% of monomer or of polymeric binder from 1 to 5% of initiator, from 0.5 to 1.5% of fluoran compound, from 0.5 to 2% of halogen compound and from 0.2 to 5% of amine.

The invention is further illustrated by the following examples.

Example A

2-anilino-6-diethylaminofluoran

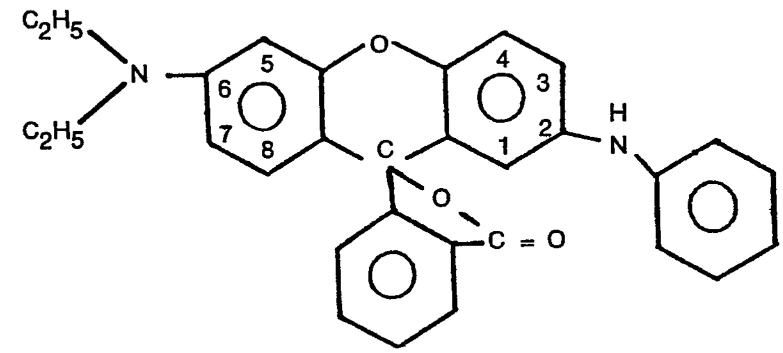

Heat together 2.2 parts by weight of 2 - carboxy - 4' - diethylamino - 2' - hydroxybenzophenone, 1 part by weight of p-nitrophenol and 40 parts by weight of 90 weight percent $H_2SO_4$ for about 1 hour at 150°C. Thereafter pour the mixture into about 225 parts by weight of ice and raise the pH to about 8 by addition of dilute $NH_4OH$. Extract this solution with benzene and thereafter wash the benzene with 10 percent by weight aqueous NaOH and then with water. Purify the washed benzene extract by passage through an activated alumina chromatograph column. Concentrate the resulting solution by evaporation, add petroleum ether and recrystallize. Reduce the product with stannous chloride solution, extract with benzene and recrystallize to obtain 2 - amino - 6 - diethylaminofluoran. Reflux 7.8 parts by weight of this product, 4 parts by weight of o-bromobenzoic acid, 2.8 parts by weight of potassium carbonate, 0.1 part by weight of copper powder and 40 parts by weight of amyl alcohol for about 3 hours. Cool and add petroleum ether to separate the crude reaction product. Heat the crude reaction product to 250—260°C to decarboxylate, then dissolve in benzene and wash twice with 1 weight percent aqueous sodium carbonate and once with water. Concentrate the benzene solution by evaporation and precipitate with petroleum ether. Dissolve the product in benzene, purify over activated alumina, recrystallize using petroleum ether and recover the product.

Example B

2-(2'-methoxycarbonyl anilino)-6-diethylamino fluoran

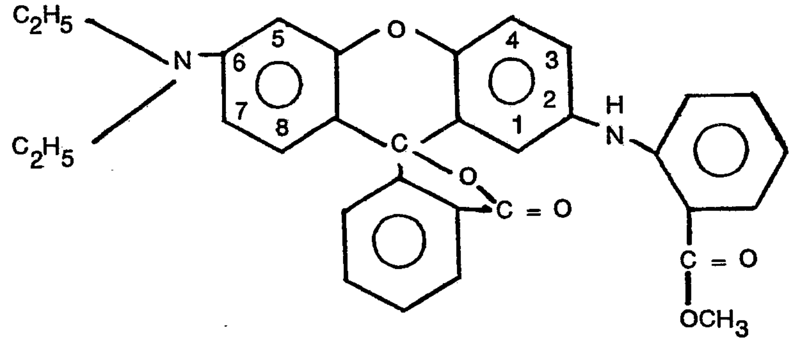

The crude reaction product of Example A is methylated by refluxing 1 part by weight of said reaction product with 0.3 parts by weight of dimethylsulfate, 0.5 parts by weight of dicyclohexylamine and 12 parts by weight of acetone for about 15 minutes. Evaporate the solvent and then heat over a steam bath for an additional 15 minutes. Extract with benzene and purify through activated alumina. Concentrate by evaporation and add petroleum ether to crystallize the reaction product.

Example C

2-(2'-methoxycarbonyl-anilino)-3-methyl-6-diethylaminofluoran

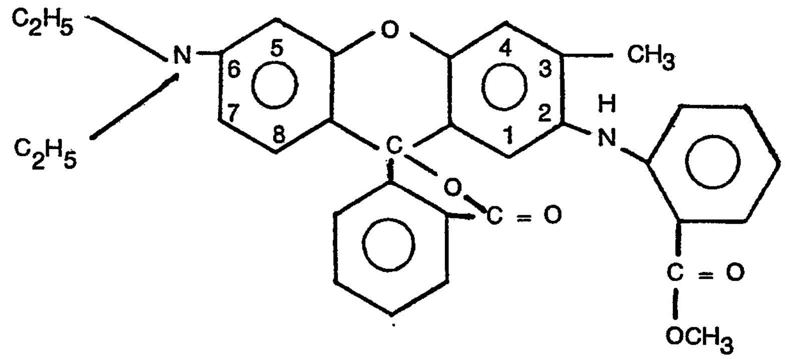

Following the procedure of Example A, but using 3-methyl-4-nitrophenol in place of p-nitrophenol, there is obtained 2 - amino - 3 - methyl - 6 - diethylaminofluoran. Reacting this product with o-bromobenzoic acid in the manner described in Example A provides the carboxylic acid-containing crude reaction product Methylating this crude reaction product according to Example B provides the desired product.

Example D

2-anilino-3-methyl-6-diethylaminofluoran

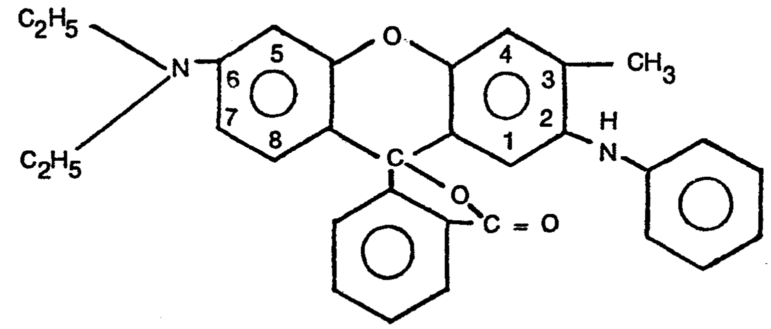

Decarboxylation of the carboxylic acid-containing crude reaction product of Example C as described in Example A, provides the desired prouct.

By an alternate route, one gram of 2'-carboxy-4-diethylamino-2-hydroxybenzophenone can be dissolved in a mixture of 4 ml. of concentrated sulfuric acid and an equal volume of fuming sulfuric acid at an $SO_3$ content of 20% with mechanical stirring, and externally cooled to about 15°C. Add 1.9 grams of 4-amino-4-methylphenol gradually and continue stirring over 16 hours at about 20°C. Thereafter, pour the reaction mixture into about 200 grams of ice-water, raise the pH to about 8 with a 10 percent by weight aqueous solution of NaOH and extract with benzene. Wash the benzene successively with 10% NaOH, 2% NaCl and then water. Concentrate by evaporation, purify over activated alumina, elute with a 3:3:1 mixture of benzene:ether:ethyl acetate, evaporate and recover the product.

Example E

2-anilino-6-diethylamino-3-methoxyfluoran

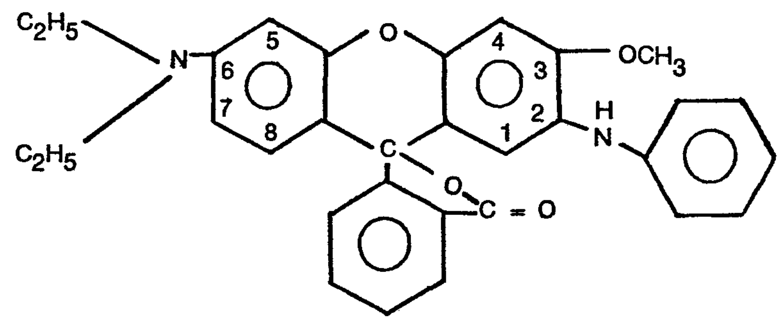

Following the alternate procedure described in Example D but using 4-amino-3-methoxyphenol instead of 4-amino-3-methylphenol, there is obtained the indicated product.

Example F

2-(N-benzylamino)-6-N-pyrrolidinylfluoran

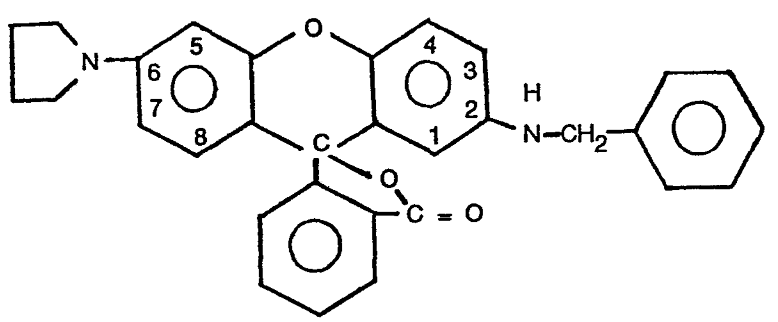

Stir a mixture of 77.75 grams of 2'-carboxy-2-hydroxy-4-N-pyrrolidinylbenzophenone 75.6 grams N-benzyl-p-anisidine and 250 ml of 98% $H_2SO_4$ at 60°C for 5 hours and then quench into 2,750 ml ice water. Filter the solid, wash with water and add the solid to a mixture of 500 ml water 250 ml methanol and 26.8 grams NaOH at 70°C. Boil this mixture for 2 hours and cool to 85°C. Filter the solid product, wash with hot water, recrystallize from methanol/acetone and dry. The starting benzophenone compound can be prepared by heating a mixture of 74 grams phthalic anhydride 81.5 grams 1-(3'hydroxyphenyl) pyrrolidine and 335 ml. xylene for 6 hours at 125°C Cool to 25°C, filter the precipitate, wash with methanol and recrystallize from ethanol.

Example G

2,6-di-(N-pyrrolidinyl) fluoran

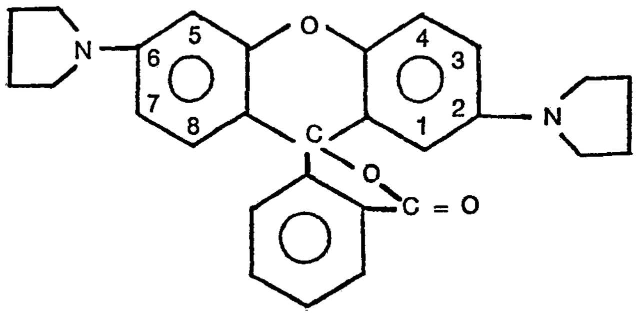

Following the procedure of Example F, but condensing the 2′-carboxy-2-hydroxy-4-N-pyrrolidinylbenzophenone with 1-(4′-hydroxyphenyl) pyrrolidine, instead of N-benzyl-p-anisidine there is obtained the indicated product.

Example H

2-methyl-4-amino-6-diethylaminofluoran

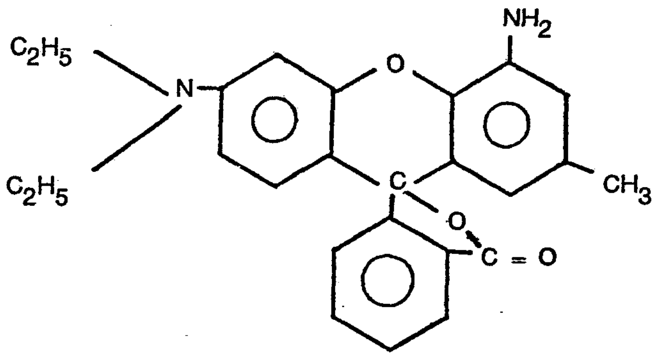

React 2′-carboxy-2-hydroxy-4-diethylamino benzophenone with 4-methyl-2-nitrophenol according to the procedure of Example A and then reduce the product by suspending the one part by weight of product in a solution of 2.5 parts by weight of stannous chloride, 2 parts by weight of HCl having a specific gravity of 1.15 and about .6 parts by a weight of water; warm and stir the suspension until a solution forms. Cool the solution to room temperature, dilute with about 2 parts by weight of water and raise the pH to about 12 with a 10 weight percent aqueous NaOH solution. Recover and purify the precipate by washing, extraction and recrystallization, as indicated in the previous examples.

Example 1

Fluoran colorformers are evaluated with respect to phototropic capacity in the following composition:

| | Parts by wt. |
|---|---|
| Acryloid A—101[a] | 60.3 (solids basis) |
| Trimethylolpropane triacrylate | 19.6 |
| Tetraethylene glycol diacrylate | 9.8 |
| Benzophenone | 3.4 |
| 2,2'-methylene bis (4-ethyl-6-t-butyl) phenol | .18 |
| Modaflow[b] | .15 |
| Tricresyl phosphate | 4.31 |
| 4.4'-bis (dimethylamino)benzophenone | 0.45 |
| Tribromoacetamide | 1.51 |
| Fluoran | 0.3 |
| | 100.0 |
| Methyl ethyl ketone | 195 |

(a) an acrylic ester polymer in organic solvent from Rohm & Haas Company.
(b) a hydrocarbon flow control agent from Monsanto Chemical Co.

The composition is coated onto a 1-mil thick polyester film and dried in air. The dry thickness of the photosensitive composition is 1—2 mils. The dried layer is covered with a 1-mil thick polyethylene film.

The phototropic capacity is determined visually by removing the polyethylene film, laminating the photopolymerizable composition to a copper-clad panel, placing a light mask over the assembly and exposing this combination to a mercury vapor lamp for 30 seconds. The image is read immediately. Zero means no image, a negative rating indicates the dye system is photofugitive (i.e., fades) while a positive rating indicates the system has darkened in response to the light and is phototropic.

The fluoran compound, color and phototropic capacity are indicated below:

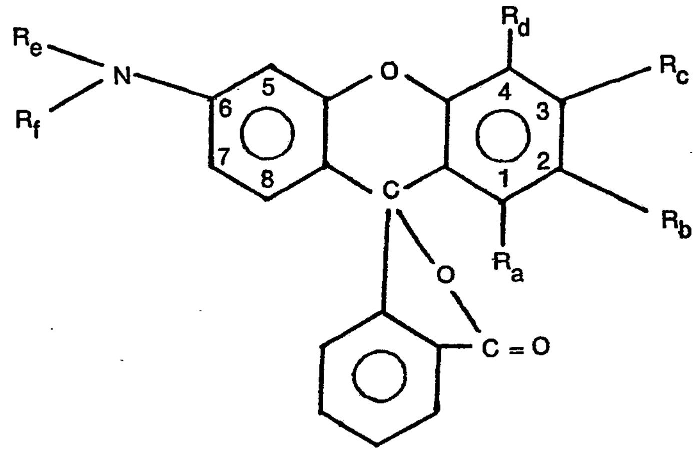

| $R_a$ | $R_b$ | $R_c$ | $R_d$ | $R_e$ | Rf | Developed Color | Phototropic Capacity |
|---|---|---|---|---|---|---|---|
| H | 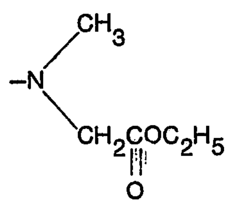 | H | H | $C_2H_5$ | $C_2H_5$ | Green | + |
| H | 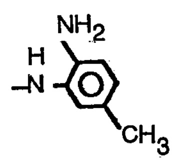 | $CH_3$ | H | $C_2H_5$ | $C_2H_5$ | Purple-Black | + |
| H | 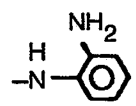 | H | H | $C_2H_5$ | $C_2H_5$ | Black | + |
| H | 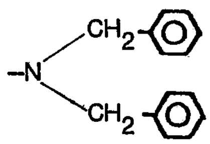 | H | H | $C_2H_5$ | $C_2H_5$ | Dark Green | + |
| H | 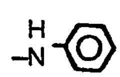 | H | H | $C_2H_5$ | $C_2H_5$ | Black | + |
| H | 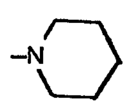 | H | H | $C_2H_5$ | $C_2H_5$ | Green | + |
| H | 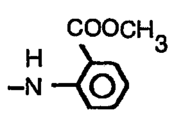 | H | H | $C_2H_5$ | $C_2H_5$ | Black | + |
| H | 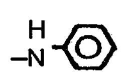 | $CH_3$ | H | $C_2H_5$ | $C_2H_5$ | Black | + |

| $R_a$ | $R_b$ | $R_c$ | $R_d$ | $R_e$ | $R_f$ | Developed Color | Phototropic Capacity |
|---|---|---|---|---|---|---|---|
| H | 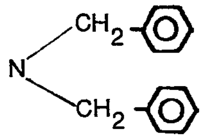 | H | H | 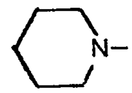 | | Green | + |
| H | $CH_3$ | H | $NH_2$ | $C_2H_5$ | $C_2H_5$ | Orange | + |
| H | $-NH_2$ | $CH_3$ | H | $C_2H_5$ | $C_2H_5$ | Purple | + |
| H | 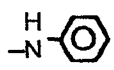 | $OCH_3$ | H | $C_2H_5$ | $C_2H_5$ | Black | + |
| H | Cl | $CH_3$ | H | $C_2H_5$ | $C_2H_5$ | Red | + |
| H | H | Cl | H | H | 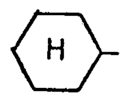 | Yellow-Orange | + |
| | 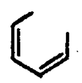 | H | H | $C_2H_5$ | $C_2H_5$ | Pink | + |
| | 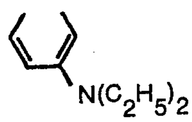 | H | H | $C_2H_5$ | $C_2H_5$ | Blue | + |
| H | 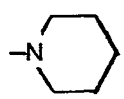 | H | H | | 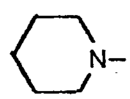 | Green | + |
| H | 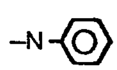 | H | H | 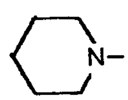 | | Black | + |
| H | $-S-CH_3$ | H | H | $C_2H_5$ | $C_2H_5$ | Red | + |
| Crystal Violet Lactone * | | | | | | – | very weak image using 5 grams |

* Crystal Violet Lactone has the structure:

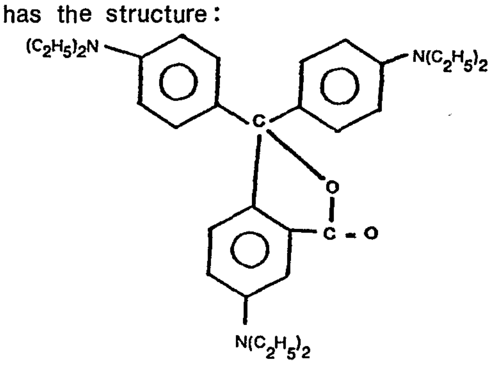

When crystal violet lactone was evaluated and found not to provide a perceptible image, the result was totally surprising, particularly in view of the structural similarity between it and the fluoran compounds described.

Example 2

A photoresist compound useful to evaluate various combinations of fluoran colorformers and halogenated compounds is prepared from the following ingredients:

| | Parts by wt. |
|---|---|
| poly(methyl methacrylate)[1] | 60.0 |
| pentaerythritol triacrylate | 32.0 |
| benzophenone | 3.2 |
| 2,2′-methylene-bis-(4-ethyl-6-t-butylphenol) | .9 |
| Fluoran colorformer | .9 |
| Halogen containing compound | 2.2 |
| 4,4′-bis(dimethylamino)benzophenone | .8 |
| methyl ethyl ketone | 150.0 |

(1) a medium molecular weight product available from E.I. duPont de Nemours & Co., Inc., Wilmington, Delaware under the trademark Elvacite 2010.

The composition is made by dissolving the methyl methacrylate polymer in the solvent, using conventional equipment at low to medium speeds, then adding the monomer and then adding the remaining ingredients.

The solution is coated onto a 1 mil thick polyester film and dried in air. The dry thickness of the sensitized layer is 1—2 mils. The dried layer is covered with a 1 mil thick polyethylene film.

The following table indicates the phototropic capacity of four representative fluoran colorformers in the presence of a variety of halogenated compounds; phototropic capacity is determined as described in Example 1.

A = 2-anilino-3-methoxy-6-diethylaminofluoran

B = 2-anilino-6-diethylaminofluoran

C = 2-piperidino-6-diethylaminofluoran

D = 2-(N,N-dibenzylamino)-6-pyrrolidinofluoran

| *Halogenated Compound* | *A* | *B* | *C* | *D* |
|---|---|---|---|---|
| carbon tetrachloride | + | + | + | + |
| carbon tetrabromide | + | + | + | + |
| iodoform | + | + | + | + |
| tris(2,3-dibromopropyl)phosphate | + | + | + | + |
| poly(dibromopropyl acrylate) | + | + | + | + |
| tetrabromobisphenol | + | + | + | + |
| methyl methacrylate/dibromopropyl acrylate copolymer | + | + | + | + |
| Chlorowax 70 | + | + | + | + |
| 2,5-dichloro-p-xylene | + | + | + | + |
| 2,3-dibromopropanol | + | + | + | + |
| trichlorocetamide | + | + | + | + |
| iodoacetamide | + | + | + | + |
| dibromoacetamide | + | + | + | + |
| 3-bromopropionamide | + | + | + | + |
| dibromomalonamide | + | + | + | + |
| 2-bromobutyramide | + | + | + | + |
| iodomolonamide | + | + | + | + |
| ethyl iodide | + | + | + | + |
| hexachloroethane | + | + | + | + |
| 1,2,3,4-tetrabromobutane | + | + | + | + |
| 1,1,1-trichloro-2-propanol | + | + | + | + |
| 1,1,1-trichloro-2-methyl-2-propanol | + | + | + | + |
| tribromo-t-butyl alcohol | + | + | + | + |
| 2,2,2-trichloroethanol | + | + | + | + |
| hexachlorocyclopentadiene | + | + | + | + |
| tetrabromocyclohexanone | + | + | + | + |
| hexabromoacetone | + | + | + | + |
| 1,1,1-trichloroacetone | + | + | + | + |
| ethyl trichloroacetate | + | + | + | + |
| dimethyl dibromomalonate | + | + | + | + |
| trichloroethyl trichloroacetate | + | + | + | + |

| Halogenated Compound | A | B | C | D |
|---|---|---|---|---|
| isooctyl trichloroacetate | + | + | + | + |
| isotrideryl trichloroacetate | + | + | + | + |
| trichloroethyl phosphate | + | + | + | + |
| N-chlorosuccinimide | + | + | + | + |
| 1,1,1-trichloro-2,2-bis-(p-chlorophenyl) ethane | + | + | + | + |
| 2-methyl-2′,4′-dichlorophenoxy ethanol | + | + | + | + |
| 2,3,4,5-tetraiodopyrrole | + | + | + | + |
| hexabromobenzene | + | + | + | + |
| hexabromobiphenyl | + | + | + | + |
| tetrabromobisphenol A | + | + | + | + |
| p-trichloroacetyl-t-butylbenzene | + | + | + | + |

### Example 3

When the procedure of Example 2 is repeated using fluoran compounds A, B, C and D and tribromoacetamide, dibromomalonamide, iodoform and tetrabromocyclohexanone and the halogenated compound with a variety of amines as hydrogen donors, the systems display phototropic capacity:

| Halogen | I | | | | II | | | | III | | | | IV | | | |
|---|---|---|---|---|---|---|---|---|---|---|---|---|---|---|---|---|
| Fluoran | A | B | C | D | A | B | C | D | A | B | C | D | A | B | C | D |
| propylamine | + | + | + | + | + | + | + | + | + | + | + | + | + | + | + | + |
| diisopropanolamine | + | + | + | + | + | + | + | + | + | + | + | + | + | + | + | + |
| triethylamine | + | + | + | + | + | + | + | + | + | + | + | + | + | + | + | + |
| dimethylethanolamine | + | + | + | + | + | + | + | + | + | + | + | + | + | + | + | + |
| N,N-dimethyl butylamine | + | + | + | + | + | + | + | + | + | + | + | + | + | + | + | + |
| p-acetylphenyl dimethylamine | + | + | + | + | + | + | + | + | + | + | + | + | + | + | + | + |
| p-caprylphenyl dimethylamine | + | + | + | + | + | + | + | + | + | + | + | + | + | + | + | + |
| p-dimethylaminophenyl acetate | + | + | + | + | + | + | + | + | + | + | + | + | + | + | + | + |
| p-dimethylaminophenyl valerate | + | + | + | + | + | + | + | + | + | + | + | + | + | + | + | + |
| ethyl dimethylaminobenzoate | + | + | + | + | + | + | + | + | + | + | + | + | + | + | + | + |
| amyl dimethylaminobenzoate | + | + | + | + | + | + | + | + | + | + | + | + | + | + | + | + |
| p-dimethylamino acetophenone | + | + | + | + | + | + | + | + | + | + | + | + | + | + | + | + |
| 4-dimethylamino benzophenone | + | + | + | + | + | + | + | + | + | + | + | + | + | + | + | + |
| 4,4'-bis-(dimethylamino)-benzophenone | + | + | + | + | + | + | + | + | + | + | + | + | + | + | + | + |
| 2,4-dichlorobenzenediazonium tetrachloroferrite (III) | + | + | + | + | + | + | + | + | + | + | + | + | + | + | + | + |

I = Tribromoacetamide II = Dibromomalonamide III = Iodoform IV = Tetrabromocyclohexanone

Example 4

Combinations of photoinitiators and amines can be evaluated using the following composition and the procedure described in Examples 2 and 3.

| | Parts by wt. |
|---|---|
| poly (methyl methacrylate)[1] | 60.0 |
| pentaerythritol triacrylate | 30.0 |
| photoinitiator | 3.2 |
| 2,2′-methylene-bis-(4-ethyl-6-t-butylphenol) | .9 |
| fluoran colorformer | .9 |
| Tribromoacetamide | 2.2 |
| amine | 2.8 |
| methyl ethyl ketone | 150.0 |

(1) Elvacite 2010 from Du Pont.

The following table indicates phototropic capacity of representative colorforms A and B of Example 2 with a variety of photoinitiators and amines.

| | Photoinitiator |
|---|---|
| 1 | benzoin |
| 2 | benzoin isobutyl ether |
| 3 | thioxanthone |
| 4 | 2-chlorothioxanthone |
| 5 | fluorenone |
| 6 | benzil |
| 7 | acetophenone |
| 8 | benzophenone |
| 9 | diethoxyacetophenone |

| Photoinitiator<br>Colorformer | 1<br>A | <br>B | 2<br>A | <br>B | 3<br>A | <br>B | 4<br>A | <br>B | 5<br>A | <br>B | 6<br>A | <br>B | 7<br>A | <br>B | 8<br>A | <br>B | 9<br>A | <br>B |
|---|---|---|---|---|---|---|---|---|---|---|---|---|---|---|---|---|---|---|
| dimethylethanolamine | + | + | + | + | + | + | + | + | + | + | + | + | + | + | + | + | + | + |
| N,N-dimethyl butylamine | + | + | + | + | + | + | + | + | + | + | + | + | + | + | + | + | + | + |
| p-acetylphenyl dimethylamine | + | + | + | + | + | + | + | + | + | + | + | + | + | + | + | + | + | + |
| p-caprylphenyl dimethylamine | + | + | + | + | + | + | + | + | + | + | + | + | + | + | + | + | + | + |
| p-dimethylaminophenyl acetate | + | + | + | + | + | + | + | + | + | + | + | + | + | + | + | + | + | + |
| p-dimethylaminophenyl valerate | + | + | + | + | + | + | + | + | + | + | + | + | + | + | + | + | + | + |
| ethyl dimethylamino benzoate | + | + | + | + | + | + | + | + | + | + | + | + | + | + | + | + | + | + |
| amyl dimethylamino benzoate | + | + | + | + | + | + | + | + | + | + | + | + | + | + | + | + | + | + |
| p-dimethylamino acetophenone | + | + | + | + | + | + | + | + | + | + | + | + | + | + | + | + | + | + |
| 4-dimethylamino benzophenone | + | + | + | + | + | + | + | + | + | + | + | + | + | + | + | + | + | + |
| 4,4'-bis (dimethylamino) benzophenone | + | + | + | + | + | + | + | + | + | + | + | + | + | + | + | + | + | + |

Example 5

The following solution is coated onto a 1 mil thick polyester film to provide a dry thickness of about 0.001 inch, and dried in air. The dried film is covered with a 1 mil thick polyethylene film.

| *Ingredients* | *Parts by wt.* |
|---|---|
| copolymer of 75% styrene and 25% methacrylic acid; viscosity of a 40% solution in MEK is 10,360 cps | 57.0 |
| trimethylolpropane triacrylate | 24.0 |
| tetraethyleneglycol diacrylate | 12.2 |
| benzophenone | 4.0 |
| 4,4′-bis-(dimethylamino)-benzophenone | 0.6 |
| 2-anilino-3-methoxy-6-diethylaminofluoran | 0.3 |
| trichloroacetamide | 1.5 |
| benzotriazole | .4 |
| methyl ethyl ketone | 160.0 |

A piece of copper clad, epoxy-fibreglass board is cleaned by scouring with an abrasive cleaner, swabbing and thoroughly rinsing in water. It is given a 20 second dip in dilute hydrochloric acid solution (2 volumes water plus 1 volume concentrate hydrochloric acid), a second rinse with water and then dried with air jets.

The polyethylene cover film is removed from a section of the sandwiched photoresist dry film described above. The bared resist coating with its polyester support is laminated to the clean copper with the surface of the photoresist in contact with the copper surface. The lamination is carried out with the aid of rubber covered rollers operating at 250°F(121°C) with a pressure of 3 pounds per lineal inch at the nip at a rate of 2 feet per minute. The resulting sensitized copper clad board protected as it is by the polyester film can be held for later use if desired. Exposure to light is had through a high contrast transparency image in which the conducting pattern appears as transparent areas on an opaque background. Exposure is carried out by placing the sensitized copper clad board (with polyester film still intact) and the transparency into a photographic printing frame. Exposure is maintained for a period of 90 seconds to a 400 watt, 50 ampere vapor lamp at a distance of 12 inches. It is seen that the area of the resist that have been exposed to light have darkened in color considerably, to a black color which contrasts substantially with the unexposed portions of the resist. The polyethylene terephthalate support film is peeled off and the exposed resist layer developed by agitating the board in a tray containing 2% trisodium phosphate in water for 2 minutes followed by a water rinse. The resulting board wich contained a deeply colored resist pattern of the clear areas of the exposing transparency is then etched in ferric chloride solution, rinsed and dried. The resist is removed from the remaining copper by dipping for 2 minutes in a 3% solution of sodium hydroxide in water at 70°C. The result is a high quality printed circuit board.

In an alternative embodiment, the surface of the exposed copper obtained after developing is further cleaned by dipping the board into a 20% ammonium persulfate bath for 30 seconds, washing copiously with water, dipping for 30 seconds in a 20% solution of hydrochloric acid in water, rinsing with water, then drying the board with jets of air. This cleaned board is then plated for 45 minutes at 30 amperes per square foot in a copper pyrophosphate plating bath at 55°C.

Example 6

A copper clad piece of epoxy-fiberglass board is cleaned as described in Example 5 above. The cleaned, dried board was sensitized by flowing the following solution over the surface of the board:

| *Ingredients* | *Parts by wt.* |
|---|---|
| Copolymer of 37% styrene and 63% monobutyl maleate, average mol. wt. 20,000, viscosity of 10% aqueous solution of ammonium salt = 150 cps. | 60.0 |
| Pentaerythritol tetraacrylate | 34.2 |
| Benzophenone | 2.5 |
| 4,4'-bis-(dimethylamino)-benzophenone | 0.3 |
| Benzotriazole | 0.2 |
| 2,2'-methylene-bis-(4-ethyl-6-tert-butylphenol) | 0.9 |
| 2-anilino-3-methoxy-6-diethylaminofluoran | 0.4 |
| Tribromoacetamide | 1.5 |
| Methyl Ethyl Ketone | 150.0 |

The excess solution is drained off the board at room temperature for 2 minutes. The coating is further dried by heating in a forced air oven at 60°C for 5 minutes.

After cooling, the coated board is exposed as described in Example 5 above, and it is seen that where the board is exposed to light, a dark color that dramatically contrasts with the unexposed portions is visible. The resist is developed by agitating the board in a solution of 2% trisophosphate in water for one minute, followed by a water rinse. The board is etched in ferric chloride as described in Example 5 and after etching, the exposed resist is stripped from the protected copper by immersing the board in a 3% solution of sodium hydroxide in water at 50°C for 2 minutes. The result is a high quality printed circuit board.

Example 7

Coating compositions are prepared from the following amounts of components:

| *Components* | *Composition, Parts by Wt.* | | | | |
|---|---|---|---|---|---|
| | I | II | III | IV | V |
| PCP[a] | 36.2 | — | — | — | — |
| EPOA[b] | 4.8 | 4.5 | — | — | — |
| E.D.[c] | 16.2 | 57.0 | 54.5 | 59.5 | 47.6 |
| NPGDA[d] | 14.2 | 18.1 | 17.3 | 19.0 | 19.0 |
| EHA[e] | 14.2 | 9.0 | 8.7 | 9.5 | 9.5 |
| DCPA[f] | 9.6 | 6.9 | 15.2 | 7.2 | 19.0 |
| Benzophenone | 4.8 | 4.5 | 4.3 | 4.8 | 4.9 |
| Colorformer[g] | 0.9 | 0.9 | 0.9 | 0.9[h] | 0.9[i] |
| Trichloroacetamide | 1.5 | 1.5 | 1.5 | 1.5 | 1.5 |
| 4,4'-bis(dimethylamino) benzophenone | .5 | .5 | .5 | .5 | .5 |

(a) 80% solution of Union Carbide PCP—0300 polycaprolactone/toluene diisocyanate oligomer in 20% hydroxyethyl acrylate
(b) polyacrylate of epoxidized soya bean oil available from Union Carbide
(c) Epon Diacrylate
(d) neopentyl glycol diacrylate
(e) 2-ethylhexyl acrylate
(f) dicyclopentenyl acrylate
(g) 2-anilino-3-methoxy-6-diethylaminofluoran
(h) 2-anilino-6- diethylaminofluoran
(i) 2-piperidino-6-diethylaminofluoran

The compositions are prepared by adding the Epon Diacrylate polymer to the monomers and mixing in conventional equipment at low to medium speeds until dissolved. The photoinitiator is added and the other ingredients are incorporated.

The coatings are applied to a cellulosic substrate (hardboard) by direct roller coating. The wet coated substrate is then exposed to UV radiation by being placed on a chain link conveyor and passed under a 200 watt/lineal inch Hanovia quartz ultraviolet lamp at a distance of about two inches at a speed of approximately 12 feet per minute.

Tough, resistant, deeply colored coatings are obtained.

## Example 8

An ink composition is prepared as follows by mixing together the following components in conventional manner.

| | |
|---|---|
| Epoxy Acrylate | 60.0 |
| Ultraflex Microcrystalline Wax | 3.3 |
| Pentaerythritol Tetraacrylate | 29.2 |
| Benzophenone | 4.5 |
| 4,4′-bis (dimethylamino)benzophenone | .50 |
| 2-anilino-3-methoxy-6-diethylaminofluoran | 1.0 |
| Trichloroacetamide | 1.50 |

When this ink is silk screened onto a paper substrate and exposed to light using a 200 watt-linear inch medium pressure mercury vapor lamp at a distance of 4 inches for about 5 seconds, there is obtained a dry, tack-free dark-printed substrate having good gloss and adhesion.

When the colorformer is replaced by the colorformers described in Example 1, there is obtained an ink that cures to a dry, tack-free deeply colored product.

## Example 9

An acrylated urethane modified polyester can be prepared as follows:

To a reaction vessel equipped with stirrer, reflux condenser thermometer and heating means charge

| | *Parts by weight* |
|---|---|
| 1,3-butylene glycol | 12.68 |
| 1,6-hexanediol | 66.64 |
| Adipic acid | 20.58 |
| Dibutyl Tin Oxide | .10 |

using a nitrogen sparge. Heat to a reflux and react to an acid value less than 3. The product will have an equivalent weight of about 501 and a molecular weight of about 1000.

To a reaction vessel equipped with a stirrer, thermometer and nitrogen sparge charge 15.22 parts by weight of 2,4-tolylene diisocyanate and heat to 50°C. Add a mixture of 10.13 parts by weight of 2-ethylhexyl acrylate and 0.0035 parts by weight of phenothiazine over a two hour period, maintaining

the temperature at 60°C during this period. Hold at 60°C for an additional three hours. Cool to 50°C and add 43.83 parts by weight of the polyester previously prepared over a one hour period, maintaining the temperature at 60°C; thereafter hold the temperature of 70°C for 3 hours. Cool to 60°C; add 0.35 parts by weight of methanol to obtain zero free isocyanate and hold an additional 1/2 hour at 60°C. Cool and store the product.

A. A UV curable composition can be prepared having the following composition:

| | *Parts by Weight* |
|---|---|
| Acrylated polyester | 66.6 |
| 1,6-hexanediol diacrylate | 14.5 |
| Pentaerythritol triacrylate | 4.6 |
| Methyl ethyl ketone | 1.9 |
| 2-ethylhexyl acrylate | 4.7 |
| Tribromacetamide | 2.0 |
| Benzophenone | 3.0 |
| 2-anilino-3-methoxy-6-diethyl aminofluoran | .7 |
| dimethylamino ethanol | 2.0 |

The composition is mixed until homogeneous. The photopolymerizable composition is applied to a wooden test piece, having a smooth surface, at the rate of 100 grams per square meter and the coated surface is covered with a 30 mm. thick untreated polyethylene film exercising care to ensure that no air bubbles are entrained. This is then exposed to actinic rays with a 2-KW high pressure mercury-vapor lamp for 30 seconds at radiation distance of 30 mm. When the polyethylene film is stripped, it is seen that a smooth cured coating is obtained having good hardness, good adhesion to the wood and that is black in color.

B. A second UV-curable system can be prepared having the following composition:

| | *Parts by Weight* |
|---|---|
| Acrylated polyester | 65.3 |
| Pentaerythritol tetrakis ($\beta$-mercaptopropionate) | 26.0 |
| Benzophenone | 3.0 |
| 2-anilino-3-methoxy-6-diethylaminofluoran | .7 |
| dimethylaminoethanol | 3.0 |
| Tribromoacetamide | 2.0 |

When coated on a wood test specimen and treated as in part A above, there is obtained a cured coating having a black color.

Example 10

A UV curable epoxide composition can be prepared having the following composition:

| | Parts by Weight |
|---|---|
| Diglycidyl ether of bisphenol A | 212 |
| (3,4-epoxycyclohexyl)-methyl 3,4-epoxycyclohexane carboxylate | 106 |
| dodecyl glycidyl ether | 32 |
| Propylene Carbonate(1) | 4.8 |
| β-chlorobenzenediazonium hexafluorophosphate | 3.5 |
| N,N-dimethylacetamide | .16 |
| 2-anilino-3-methoxy-6-diethyl-aminofluoran | 2.5 |

(1) A cyclic propylene ester of carbonic acid identified as 4-methyl-1,3-dioxolan-2-one.

Mix the propylene carbonate, diazonium halide and acetamide and stir into a homogeneous mixture of epoxide and dyestuff.

When this composition is coated on a wood test piece and exposed to UV radiation as in Example 9, but without the cover sheet, there is obtained a cured coating having a black color.

**Claims**

1. A phototropic photosensitive composition, such as a film, comprising (a) at least one component which is capable of curing, crosslinking or polymerizing upon initiation, such as a compound containing an acrylyl or methacrylyl group, (b) at least one initiator for the component (a) which is potentiated by actinic radiation, (c) the free base of a dyestuff that forms a halide salt which is more intensely coloured than the free base, and (d) a latent activator which releases free halogen radicals when exposed to actinic light and comprises a halogen-containing organic compound, said composition being characterized in that it contains the free base of a fluoran dyestuff that forms a halide salt and has the general formula

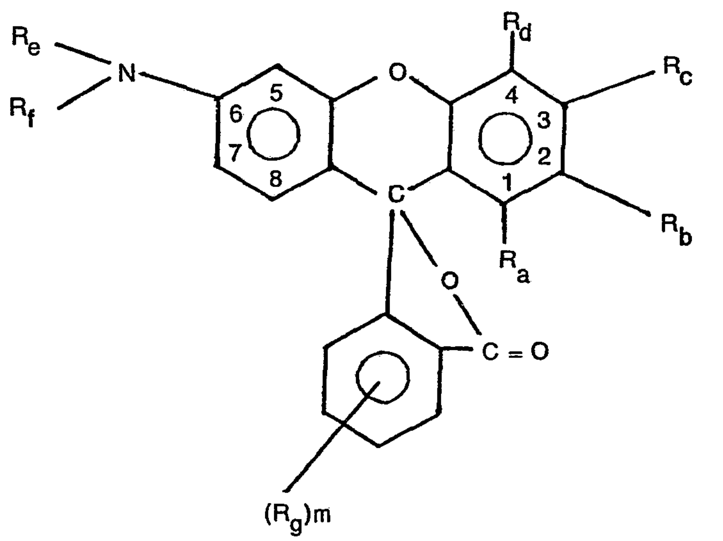

in which $R_a$ is a hydrogen or halogen atom or an aliphatic hydrocarbon or hydrocarbonoxy group having 1 to 12 carbon atoms which may be interrupted by —NH— or —O— and may be substituted: Rb is a primary, secondary or tertiary amino group in which the substituents on the nitrogen atom, when present, are aliphatic, cycloaliphatic, aromatic or araliphatic hydrocarbon groups which may be substituted or Rb is a heterocyclic group having 2 to 12 ring atoms which is linked through a nitrogen atom and may, in addition, have oxygen and/or sulphur as ring atoms; or $R_a$ and $R_b$ may together form a condensed aromatic nucleus, $R_c$ is a hydrogen or halogen atom or an aliphatic hydrocarbon or

hydrocarbonoxy group having 1 to 12 carbon atoms which may be interrupted by nitrogen or oxygen, or a primary, secondary or tertiary amino group in which the substituents on the nitrogen atom, when present, are aliphatic, cycloaliphatic, aromatic or araliphatic hydrocarbon groups which may be substituted, or $R_c$ is a heterocyclic group having 3 to 12 ring atoms and may, in addition, have oxygen and/or sulphur as ring atoms, or $R_c$ is an aromatic hydrocarbon group which may be substituted, an araliphatic group or an aromatic ether or an aromatic-aliphatic ether group; $R_d$ is a hydrogen atom, a lower aliphatic hydrocarbon or hydrocarbonoxy group or a primary, secondary or tertiary amino group in which the substituents on the nitrogen atom, when present, are aliphatic, cycloaliphatic, aromatic or araliphatic hydrocarbon groups which may be substituted or Rd is a heterocyclic group having 3 to 12 ring atoms and containing one or more of nitrogen, oxygen and sulphur as ring atoms: each of Re and Rf is a hydrogen atom or an aliphatic hydrocarbon group having 1 to 12 carbon atoms and may be substituted and may be interrupted by oxygen or nitrogen, a cycloaliphatic, aromatic or araliphatic hydrocarbon group or Re and Rf together with the nitrogen atom to which they are attached form a heterocyclic ring having 3 to 12 ring atoms and may, in addition, have oxygen and/or sulphur as ring atoms: each (Rg) is a hydrogen or halogen atom, a lower aliphatic hydrocarbon or hydrocarbonoxy group, or an acetamido or primary, secondary or tertiary amino group; m is an integer from 1 to 3 and at least one of Rb, Rc and Rd is an amino group.

2. A composition as claimed in claim 1 further characterised in that the free base of said dyestuff has the general formula

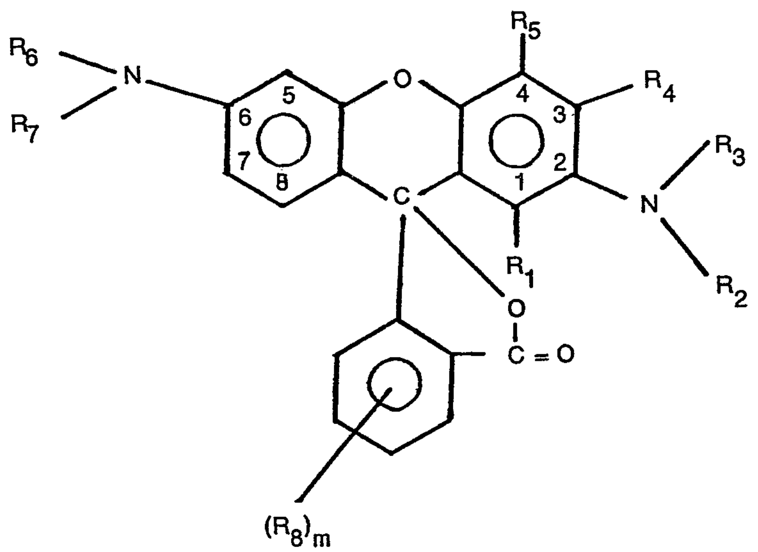

in which R1 is as a hydrogen or halogen atom or an alkyl or alkoxy group having 1 to 12 carbon atoms, each of R2 and R3 is a hydrogen atom, an alkyl group having 1 to 12 carbon atoms, an alkenyl group having 2 to 12 carbon atoms, an alkoxyalkyl group having 2 to 8 carbon atoms, an alkoxycarbonylalkyl group having 2 to 9 carbon atoms, a cycloalkyl group having 5 or 6 carbon atoms, an acyl group having 1 to 12 carbon atoms or a phenyl, naphthyl or benzyl group which may be substituted in one to three nuclear positions by any of amino, mono-or dialkylamino groups having 1 to 5 carbon atoms, alkyl or alkoxy groups having 1 to 7 carbon atoms, carboxyl, alkoxycarbonyl groups having 2 to 7 carbon atoms, acyl or acylamino groups having 1 to 5 carbon atoms or —$SO_3Me$ wherein Me is an alkali metal, or R3 and R2 taken together with the nitrogen atom to which they are attached together form a pyrrolidinyl, piperidyl, pipecolinyl, perhydroazepinyl, heptamethyleneimino, octamethyleneimino, indolinyl, 1, 2, 3,—4-tetrahydroquinolinyl, hexahydrocarbazolyl, morpholinyl, thiomorpholinyl thiomorpholinyl, piperazinyl, an N-alkylpiperazinyl group having 1 to 4 carbon atoms in the alkyl group, a pyrazolinyl or 3-methylpyrazolinyl group, R4 is a hydrogen or halogen atom, an alkyl or alkoxy group having 1 to 12 carbon atoms or is a group having the formula —$NR_2R_3$ in which R2 and R3 are as defined above or R4 is a phenyl, phenoxy, benzyl or benzyloxy group which is either unsubstituted or which may be substituted in 1 to 3 nuclear positions by any of amino, mono- or di-alkylamino having 1 to 5 carbon atoms, lower alkyl or alkoxy, carboxyl, alkoxycarbonyl having 2 to 7 carbon atoms, acyl having 1 to 5 carbon atoms or $MeSO_3$—wherein Me is an alkali metal, R5 is a hydrogen atom, a lower alkyl or alkoxy group or is a group having the formula —$NR_2R_3$ in which $R_2$ and $R_3$ are as defined above, each of $R_5$ and $R_6$ is a group having the formula —$NR_2R_3$ in which $R_2$ and $R_3$ are as defined above, each $R_8$ is a hydrogen or halogen atom, an alkyl or alkoxy group having 1 to 7 carbon atoms, acetamido, amino or mono- or di-alkylamino having 1 to 7 carbon atoms and *m* is as defined in claim 1.

3. A composition as claimed in either of claim 1 or 2, further characterized in that the latent activator (d) comprises a proton donor and a halogen-containing organic compound.

4. A composition as claimed in claim 3, further characterized in that the proton donor comprises a p-aminophenyl ketone having the general formula

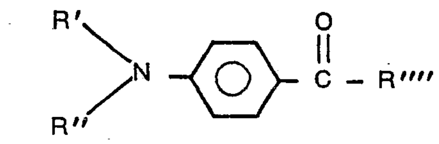

in which each of R′ and R″ is an alkyl group having 1 to 4 carbon atoms and R'''' is an alkyl or alkoxy group having 1 to 12 carbon atoms or a phenyl, lower alkyliminiphenylene or di(lower alkyl) aminophenylene group.

5. A composition as claimed in either of claims 3 or 4 further characterized in that the halogenated compound has the general formula

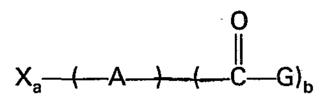

in which X is Cl, Br or I, *a* is an integer from 1 to 4, A is an alkyl or alkenyl group having 1 to 7 carbon atoms and G is —OA′ or —NH—A″ in which A′ is alkyl or haloalkyl group having 1 to 15 carbon atoms and halo is Cl Br or I and A″ is a hydrogen atom, an alkyl or haloalkyl group having 1 to 4 carbon atoms and halo is Cl, Br or I and *b* is 1 or 2.

6. A composition as claimed in any of claims 3—5, in which said polymerisable or crosslinkable component (a) is a mixture of a preformed crosslinkable polymer and a polymerisable monomeric component.

7. A composition as claimed in claim 6 characterized in that it comprises

(i) 40 to 68,79% by weight of said preformed polymer,

(ii) 30 to 50% by weight of said polymerisable component,

(iii) 1 to 10% by weight of initiator (b),

(iv) 0.01 to 2% by weight of the free base of said fluoran dyestuff,

(v) 0.1 to 5% by weight of said halogen-containing organic compound, and

(vi) 0.1 to 10% by weight of an amine which acts as a proton donor.

8. A composition as claimed in any of the preceding claims further characterized in that it is the form of a thin film.

**Revendications**

1. Composition photosensible phototropique telle qu'une pellicule comprenant (a) au moins un corps qui peut, après initiation, être développé, lié par liaisons transversales ou polymérisé et qui est constitué d'un composé du groupe des acryliques ou des méthacryliques, (b) au moins un initiateur pour ledit corps (a) qui est activé par un rayonnement actinique, (c) la base libre d'un colorant qui form un sel d'haloïdes qui présente une coloration plus intense que celle de ladite base libre et (d) un activateur latent qui dégage des radicaux libres d'halogènes lorsqu'il est exposé à une lumière actinique et comprend un corps organique contenant de l'halogène, caractérisé en ce qu'elle comprend une base libre d'un colorant fluoré qui forme un sel d'haloïdes et présente la structure générale suivante:

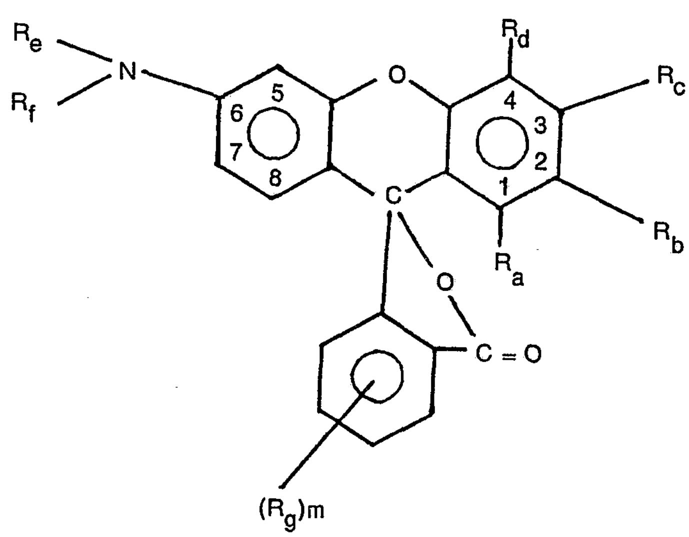

dans laquelle Ra est un atome d'hydrogène ou d'halogène ou groupe d'hydrocarbure aliphatique ou d'oxyde d'hydrocarbure contenant de l'ordre de 1 à 12 atomes de carbone et qui peut être interrompu par un —NH— ou un —O— et être substitué; Rb étant un groupe d'amide primaire, secondaire ou tertiaire dans lequel les substituts de l'atome d'azote sont, le cas échéant, des groups d'hydrocarbures aliphatiques cycloaliphatiques, aromatiques ou araliphatiques qui peuvent être substitués, Rb pouvant également étre un groupe hétérocyclique comprenant de l'ordre de 2 à 12 atomes d'anneaux liés par un atome de nitrogène (azote) et qui peut, de plus, comprendre des atomes d'anneaux d'oxygène et/ou de soufre, Ra et Rb pouvant également former ensemble un noyau aromatique condensé, Rc étant un atome d'hydrogène ou d'halogène ou encore un groupe d'hydrocarbure aliphatique ou d'oxyde d'hydrocarbure contentant de l'ordre de 1 à 12 atomes de carbone et qui peut être interrompu par de l'azote ou de l'oxygène ou encore par un groupe d'amide primaire, secondaire ou tertiaire dans lequel les substituts de l'atome d'azote sont le cas échéant des groupes h'ydrocarbures aliphatiques, cycloaliphatiques, atomatiques ou araliphatiques qui peuvent étre substitués; Rc pouvant également étre un groupe hétérocyclique comprenant de l'ordre de 3 à 12 atomes d'anneaux etr de plus comprendre des atomes d'anneaux d'oxygène et/ou de soufre, Rc pouvant encore être un groupe d'hydrocarbures aromatiques qui peut être substitué, un groupe araliphatique, un éther aromatique ou un groupe d'éther aromatique aliphatique; Rd étant un atome d'hydrogène un hydrocarbure aliphatique inférieur, un groupe d'oxyde d'hydrocarbure ou un groupe d'amide primaire, secondaire ou tertiaire dans lequel les substituants de l'atome d'azote sont, le cas échéant, des groups d'hydrocarbure aliphatique, cycloaliphatiques, aromatiques ou araliphatiques qui peuvent être substitués, Rd pouvant encore étre un groupe hétérocyclique comprenant de l'ordre de 3 à 12 atomes d'anneaux et un ou plusieurs atomes d'anneaux d'azote, d'oxygène et de soufre; Re et Rf étant chacun un atome d'hydrogène ou un groupe d'hydrocarbure aliphatique comprenant de l'ordre de 1 à 12 atomes de carbone et qui peut être substitué et étre interrompu par de l'oxygène, de l'azote ou encore par un groupe d'hydrocarbure cycloaliphatique, aromatique ou araliphatique; l'ensemble de Re et Rf avec un atome d'azote auquel il est lié pouvant encore former un anneau hétérocyclique comprenant de l'ordre de 3 à 12 atomes d'anneaux et comprendre de plus des atomes d'anneaux d'oxygène et/ou de soufre; chaque composant (Rg) étant un atome d'hydrogène ou d'halogène, un groupe inférieur d'hydrocarbure aliphatique ou d'oxyde h'hydrocarbure ou encore un groupe d'acétate d'amide ou d'amide primaire, secondaire ou tertiaire, m étant un nombre entier compris entre 1 et 3 et au moins l'un des composants Rb, Rc et Rd est und groupe d'amide.

2. Compositon suivant la revendication 1, caractérisée en ce que la base libre dudit colorant présente la structure générale suivante:

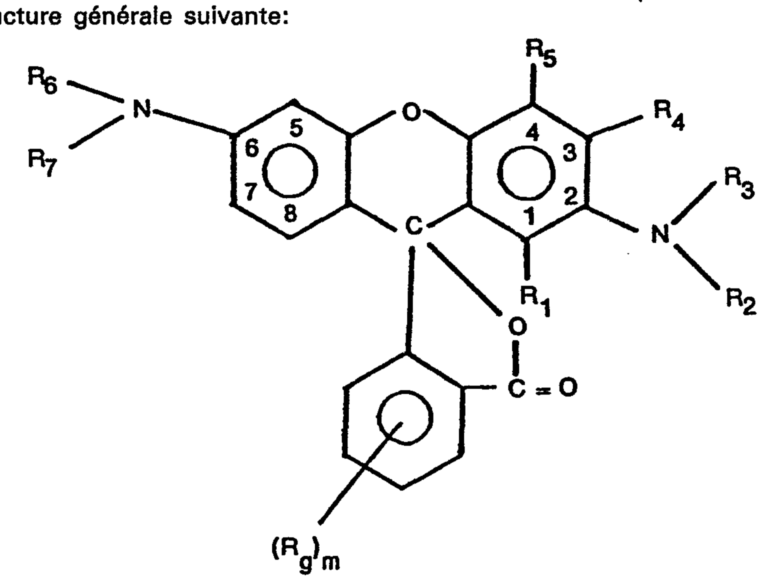

Dans cette formule, $R_1$ est un atome d'hydrogène ou d'halogène ou encore un groupe d'alcoyle ou d'alcoolate comprenant de l'ordre de 1 à 12 atomes de carbone, $R_2$ et $R_3$ étant formés chacun d'un atome d'hydrogène, d'un groupe d'alcoyle comprenant de l'ordre de 1 à 12 atomes de carbone, d'un groupe d'alkényle comprenant de l'ordre de 2 à 12 atomes de carbone, d'un groupe d'alcoolate d'alcoyle comprenant de l'ordre de 2 à 8 atomes de carbone, d'un groupe d'alcoyle d'alcoolate de carbone comprenant de l'ordre de 2 à 9 atomes de carbone, d'un groupe de cycloalcoyle comprenant de l'ordre de 5 à 6 atomes de carbone, d'un groupe d'alcyle comprenant de l'ordre de à 12 atomes de carbone ou encore par un groupe de phényle, de naphtyle ou benzyle qui peut être substitué dans une à trois positions par un groupe quelconque de mono ou dialcoyle d'amide comprenant de l'ordre de 1 à 5 atomes de carbone, par des groupes d'alcoyle ou d'alcoolate comprenant de l'ordre de 1 à 7 atomes de carbone, par des groupes de carboxyle et de carbonyle alcoolatés comprenant de l'ordre de 2 à 7 atomes de carbone, par des groupes d'acyle ou d'acyle d'amide comprenant de l'ordre de 1 à 5 atomes

de carbone ou encore par un composant $SO_3Me$ dans lequel Me est un métal alcohoïde, $R_3$ et $R_2$ ensemble avec l'atome d'azote qui les relie entre eux pouvant encore former un groupe de pyrrolidinyle, de piperidyle, de pipercolinyle, de perhydroazepinyle, d'heptamethyleneimine, d'octaméthylèneimine, d'indolinyle, 1, 2, 3, 4-tétrahydroquinolinyle, d'hexahydrocarbazolyle, de morpholinyle, de thiomorpholinyle, de piperazinyle, ou N-alcoyle-pipérazinyle ayant de l'ordre de 1 à 4 atomes de carbone dans le groupe d'alcoyle, un groupe de pyrazolinyle ou de 3-méthylpyrazolinyle, $R_4$ étant un atome d'hydrogène ou d'halogène, un groupe d'alcoyle ou d'alcoolate comprenant de l'ordre de 1 à 12 atomes de carbone ou un groupe présentant la formule $NR_2R_3$ dans laquelle $R_2$ et $R_3$ sont tels que définis ci-dessus; $R_4$ pouvant également être formé d'un groupe de phényle, de phénoxy, de benzyle ou de benzyloxy qui est non substitué ou substitué dans une à trois positions par un groupe quelconque d'amide ou de mono ou dialcoyle d'amide ayant de l'ordre de 1 à 5 atomes de carbone, d'un alcoyle inférieur ou d'un alcoolate, d'un carboxyle, d'un carbonyl d'alcoyle ayant de l'ordre de 2 à 7 atomes de carbone, d'un acyle ayant de l'ordre de 1 à 5 atomes de carbone ou d'un composé $MeSO_3$ dans lequel Me est un métal alcaloïde; $R_5$ étant un atome d'hydrogène, un groupe d'alcoyle inférieur ou d'alcoolate ou un groupe ayant la formule $NR_2R_3$ dans laquelle $R_2$ et $R_3$ sont tels que définis ci-dessus; $R_5$ et $R_6$ sont chacun formés par un groupe ayant la formule $NR_2N_3$ dans laquelle $R_2$ et $R_3$ sont tels que définis ci-dessus; chaque composant $R_8$ est un atome d'hydrogène ou d'hydrogène, un group d'alcoyle ou d'alcoolate ayant de l'ordre de 1 à 7 atomes de carbone, un acétamide, un amide ou un mono ou dialcoyle d'amide ayant de l'ordre de 1 à 7 atomes de carbone et m étant tel que défini dans la revendication 1.

3. Composition suivant l'une quelconque des revendications 1 ou 2, caractérisée en ce que l'activateur latent (d) comprend un donneur de protons et un corps organique contenant de l'halogène.

4. Composition suivant la revendication 3, caractérisée en ce que ledit donneur de protons comprend un p-aminophényle-cétone présentant la structure générale suivante

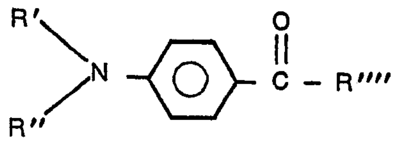

dans laquelle R′ et R″ sont chacun un groupe d'alcoyle comprenant de l'ordre de 1 à 4 atomes de carbone et R‴ est un groupe d'alcoyle ou alcoolate comprenant de l'ordre de 1 à 12 atomes de carbone ou encore un phényle, un iminiphénylène d'alcoyle inférieur ou un groupe de di(alcoyle inférieur) aminophénylène.

5. Composition suivant l'une quelconque des revendications 3 ou 4, caractérisée en ce que ledit corps contenant de l'halogéne présente la formule générale suivante

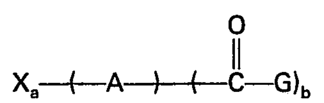

dans laquelle X est un Cl, un Br ou un I, *a* étant un nombre entier compris entre 1 et 4, A étant un groupe d'alcoyle ou d'alkényle comprenant de l'ordre de 1 à 7 atomes de carbone et G correspondant à la formule OA′ ou —NH—A″ dans laquelle A′ est un groupe d'alcoyle ou d'haloalcoyle comprenant de l'ordre de 1 à 15 atomes de carbone de radical "halo" est un Cl, un Br ou un I, A″ est un atome d'hydrogène, un groupe d'alcoyle d'haloalcoyle comprenant de l'ordre de 1 à 4 atomes de carbone tandis que le radical "halo" est un Cl, un Br ou un I, b étant égal à 1 ou 2.

6. Composition suivant l'une quelconque des revendications 3 à 5, caractérisée en ce que ledit corps polymérisable ou liable par liaisons transversales (a) est constitué d'un mélange d'un polymère préformé formant des liaisons transversales et d'un composant monomère polymérisable.

7. Composition suivant la revendication 6, caractérisée en ce qu'elle présente la composition suivante:

(i) 40 à 79% en poids dudit polymère préformé,
(ii) 30 à 50% en poids dudit corps polymérisable,
(iii) 1 à 10% en poids de l'initiateur (b),
(iv) 0.01 à 2% en poids de la base libre dudit colorant fluoré,
(v) 0.1 à 5% en poids dudit corps organique contenant de l'halogène,
(vi) 0.1 à 10% en poids d'un amide servant de donneur de protons.

8. Composition suivant l'une quelconque des revendications précédentes, caractérisée en ce qu'elle se présente sous forme d'un film de faible épaisseur.

**Patentansprüche**

1. Phototropes, lichtempfindliches Material, wie etwa ein Film, mit (a) wenigstens einer, auf eine Reaktionseinleitung hin härtbaren vernetzbaren oder polymerisierbaren Komponente, wie etwa eine

Acrylyl- oder Methacrylyl-Gruppen aufweisende Verbindung, (b) wenigstens einem Initiator für die Komponente (a), der mittels aktinischer Strahlung aktivierbar ist, (c) der freien Base einer Farbstoffverbindung, welche ein stärker als die freie Base gefärbtes Halogenidsalz bildet, und mit (d) einem latenten Aktivator, der eine organische, halogenhaltige Verbindung aufweist und bei Einwirkung von aktinischer Strahlung freie Halogenradikale freisetzt, dadurch gekennzeichnet, daß das Material die freie Base einer Fluoran-Farbstoffverbindung der nachstehenden allgemeinen Strukturformel enthält, welche eine Halogenidsalz zu bilden vermag:

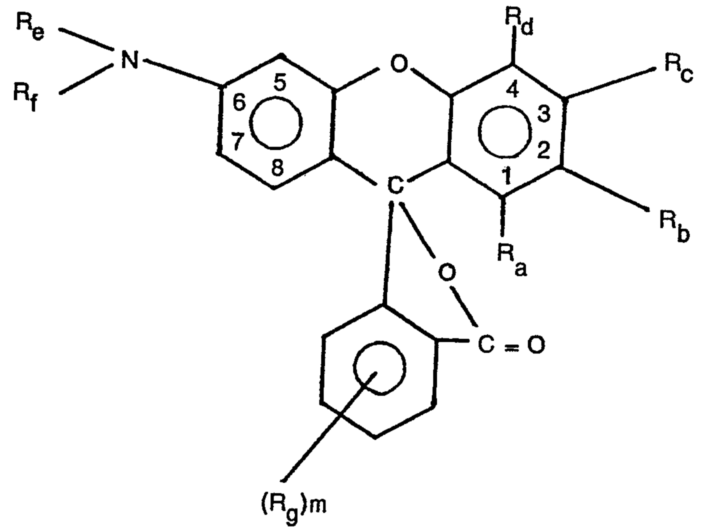

hierbei bedeuten:

$R_a$ ein Wasserstoff- oder Halogenatom oder einen aliphatischen $C_{1-12}$-Kohlenwasserstoff- oder Oxy-Kohlenwasserstoff-Rest, der von —NH— oder —O— Gruppen unterbrochen sowie substituiert sein kann; $R_b$ eine primäre, sekundäre oder tertiäre Aminogruppe, deren Substituenten am Stickstoff (soweit vorhanden) aliphatische, cycloaliphatische, aromatische oder aromatisch-aliphatische Kohlenwasserstoffe sind, die ihrerseits substituiert sein können; oder $R_b$ steht für eine heterocyclische Gruppe mit 3 bis 12, über ein Stickstoffatom verknüpfte Ringatome, wobei zusätzlich Sauerstoff und/oder Schwefel als Ringatome auftreten können; oder $R_a$ und $R_b$ stehen zusammen für einen kondensierten aromatischen Kern; $R_c$ eine Wasserstoff- oder Halogenatom oder einen aliphatischen $C_{1-12}$-Kohlenwasserstoff- oder Oxy-Kohlenwasserstoff-Rest, der von Stickstoff oder Sauerstoff unterbrochen sein kann, oder eine primäre, sekundäre oder tertiäre Aminogruppe, deren Substituenten am Stickstoff (soweit vorhanden) aliphatische, cycloaliphatische, aromatische oder aromatisch-aliphatische Kohlenwasserstoffe sind, die ihrerseits substituiert sein können; oder $R_c$ steht für eine heterocyclische Gruppe mit 3 bis 12 Ringatomen, wobei zusätzlich Sauerstoff und/oder Schwefel als Ringatome auftreten können; oder $R_c$ steht für einen gegebenenfalls substituierten aromatischen Kohlenwasserstoffrest, einen aromatisch-aliphatischen Rest oder einen aromatischen Äther oder einen aromatisch-aliphatischen Ätherrest; $R_d$ ein Wasserstoffatom oder einen niederen aliphatischen Kohlenwasserstoff- oder Oxy-Kohlenwasserstoff-Rest oder eine primäre, sekundäre oder tertiäre Aminogruppe, deren Substituenten am Stickstoff (soweit vorhanden) aliphatische, cycloaliphatische, aromatische oder aromatischaliphatische Kohlenwasserstoffe sind, die ihrerseits substituiert sein können; oder $R_d$ steht für eine heterocyclische Gruppe mit 3 bis 12. Ringatomen, welche eine oder mehrere Stickstoff- Sauerstoff- und Schwefelatome als Ringatome aufweist; $R_e$ und $R_f$ gleichermaßen ein Wasserstoffatom oder einen aliphatischen $C_{1-12}$-Kohlenwasserstoff-Rest der substituiert sein kann, sowie von Sauerstoff oder Stickstoff unterbrochen sein kann, oder einen cycloaliphatischen, aromatischen oder aromatisch-aliphatischen Kohlenwasserstoffrest; oder $R_e$ und $R_f$ stehen zusammen mit dem Stickstoffatom, mit dem sie verknüpft sind, für einen heterocyclischen Ring mit 3 bis 12 Ringatomen, der zusätzlich Sauerstoff und/oder Schwefel als Ring.atome aufweisen kann; jeder Substituent ($R_g$) ein Wasserstoff- oder Halogenatom, oder einen niederen aliphatischen Kohlenwasserstoff- oder Oxy-Kohlenwasserstoff-Rest oder eine Acetamido-Gruppe oder eine primäre, sekundäre oder tertiäre Aminogruppe; und wobei wenigstens einer der Substituenten $R_b$, $R_c$ und $R_d$ für eine Aminogruppe steht.

2. Material nach Anspruch 1, dadurch gekennzeichnet, daß die freie Base der Farbstoffverbindung der nachstehenden allgemeinen Strukturformel entspricht:

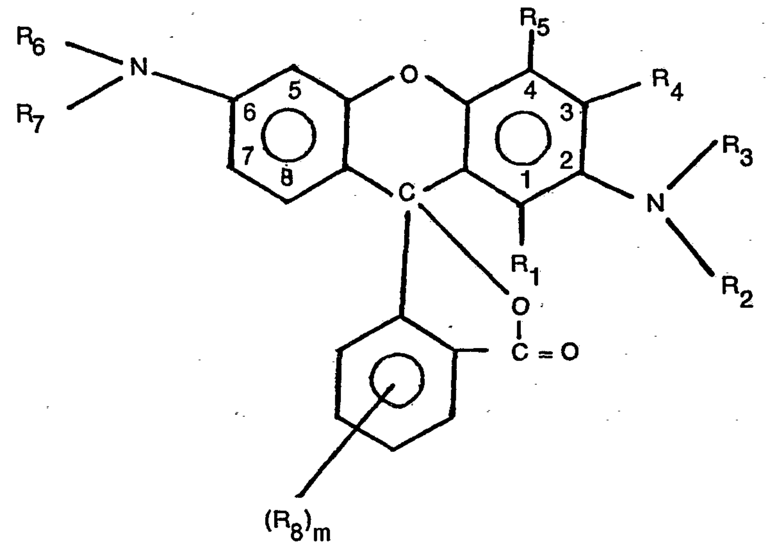

worin bedeuten:

$R_1$ ein Wasserstoff- oder Halogenatom oder ein $C_{1-12}$-Alkyl;- oder Alkoxy-Rest; $R_2$ und $R_3$ gleichermaßen ein Wasserstoffatom, ein $C_{1-12}$-Alkylrest, eine $C_{2-12}$-Alkenylgruppe, ein $C_{2-8}$-Alkoxyalkylrest, ein $C_{2-9}$-Alkoxycarbonyl- alkylrest, eine $C_{5\ \mathrm{oder}\ 6}$-Cycloalkylgruppe, ein $C_{1-12}$-Acylrest oder eine Phenyl-, Naphtyl- oder Benzylgruppe, die ihrerseits an 1 bis 3 Kernpositionen mit Aminoresten, Mono- oder Dialkylaminoresten mit 1 bis 5 Kohlenstoffatomen, mit $C_{1-7}$-Alkyl- oder Alkoxyresten, mit $C_{2-7}$-Carboxyl- oder Alkoxycarbonylresten, mit $C_{1-5}$-Acyl- oder Acylaminoresten oder mit $-MeSO_3-$ Resten substituiert sein können, worin Me für ein Alkalimetall steht; oder $R_3$ und $R_2$ stehen zusammen mit dem Stickstoffatom, mit dem sie verknüpft sind, für einen Pyrrolidinyl-, Piperidyl-, Pipecolinyl-, Perhydroazepinyl-, Heptamethylenimino-, Octamethylenimino-, Indolinyl-, 1,2,3,4-Tetrahydrochinolinyl-, Hexahydrocarbazolyl-, Morpholinyl-, Thiomorpholinyl-, Piperazinyl- Rest oder für einen N-Alkylpiperazinylrest mit $C_{1-4}$-Alkylgruppen oder für einen Pyrazolinyl- oder 3-Methylpyrazolinyl-Rest; $R_4$ ein Wasserstoff- oder Halogenatom, ein $C_{1-12}$-Alkyl- oder Alkoxyrest oder einen Rest der Formel $-NR_2R_3-$, in welchem $R_2$ und $R_3$ die oben angegebene Bedeutung haben; oder $R_4$ steht für eine Phenyl-, Phenoxy-, Benzyl- oder Benzyloxy-Gruppe, die unsubstituiert sein kann, oder die in den 1 bis 3 Positionen des Kerns mit einer Aminogruppe, mit einer Mono- oder Di-Alkylaminogruppe mit 1 bis 5 Kohlenstoffatomen, mit einem niederen Alkyl- oder Alkoxyrest, mit einem $C_{2-7}$-Carboxyl- oder Alkoxycarbonyl-Rest, mit einem $C_{1-5}$-Acylrest oder mit einem $-MeSO_3-$ Rest substituiert sein kann, worin Me für ein Alkalimetall steht; $R_5$ ein Wasserstoffatom, einen niederen Alkyl- oder Alkoxyrest oder eine Gruppe der Formel $-NR_2R_3-$, in welcher $R_2$ und $R_3$ die oben angegebene Bedeutung haben; oder jeder der Substituenten $R_5$ und $R_6$ stehen für eine Gruppe der Formel $-NR_2R_3-$, in welcher $R_2$ und $R_3$ die oben angegebene Bedeutung haben; jeder der Substituenten $R_8$ ein Wasserstoff- oder Halogenatom, einen $C_{1-7}$-Alkyl- oder Alkoxyrest, einen Acetamidorest, eine Aminogruppe oder eine Mono- oder Di-Alkylaminogruppe mit $C_{1-7}$-Alkyl-Resten; und m eine ganze Zahl von 1 bis 3.

3. Material nach einem der Ansprüche 1 oder 2, dadurch gekennzeichnet, daß der latente Aktivator (d) einen Protonendonator und eine halogenhaltige organische Verbindung aufweist.

4. Material nach Anspruch 3, dadurch gekennzeichnet, daß der Protonendonator ein p-Aminophenylketon der nachstehenden allgemeinen Strukturformel ist:

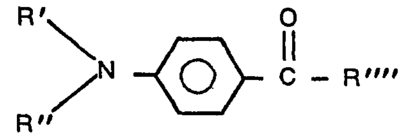

worin bedeuten:

R′ und R″ gleichermaßen einen $C_{1-4}$-Alkylrest; und R″″ ein $C_{1-12}$-Alkyl- oder Alkoxyrest oder eine Phenylgruppe, eine niedere Alkliminophenylengruppe oder eine Di-(niederes Alkyl)-Aminophenylengruppe.

5. Material nach einem der Ansprüche 3 oder 4, dadurch gekennzeichnet, daß die halogenhaltige Verbindung der nachstehenden allgemeinen Strukturformel entspricht

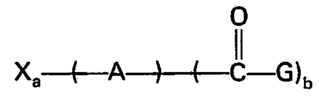

worin bedeuten:
X Chlor, Brom oder Jod; a eine ganze Zahl von 1 bis 4; A eine $C_{1-7}$-Alkyl- oder Alenylgruppe; G den Rest- OA' oder —NH—A", wobei seinerseits A' für einen $C_{1-15}$-Alkyl- oder Halogenalkyl-Rest steht mit Chlor, Brom oder Jod als Halogenatomen und A" seinerseits für ein Wasserstoffatom, einen $C_{1-4}$-Alkyl- oder Halogenalkyl-Rest steht mit Chlor, Brom oder Jod als Halogenatomen; und b die ganzen Zahlen 1 oder 2.

6. Material nach einem der Ansprüche 3 bis 5, dadurch gekennzeichnet, daß die polymerisierbare oder vernetzbare Komponente (a) ein Gemisch aus einem vorgeformten, vernetzbaren Polymerisat und einer polymerisierbaren monomeren Komponente ist.

7. Material nach Anspruch 6, gekennzeichnet durch die nachstehenden Anteile:
(u) 40 bis 68—79 Gew.-% vorgeformtes Polymerisat;
(v) 30 bis 50 Gew.-% polymerisierbare Komponente;
(w) 1 bis 10 Gew.-% Initiator (b);
(x) 0,01 bis 2 Gew.-% freie Base der Fluoran-Farbstoffverbindung;
(y) 0,1 bis 5 Gew.-% halogenhaltige organische Verbindung; und
(z) 0,1 bis 10 Gew.% als Protonendonator wirkendes Amin.

8. Material nach einem der Ansprüche 1 bis 7, dadurch gekennzeichnet, daß das Material in Form einer Dünnschicht vorliegt.